# EUROPEAN PATENT SPECIFICATION

(11) **EP 3 183 748 B1**
(45) Date of publication and mention of the grant of the patent: **10.03.2021**
(21) Application number: 15756514.4
(22) Date of filing: 14.08.2015
(51) Int. Cl.: H01L 27/11556, H01L 27/11582, H01L 21/28

(54) **FLOATING GATE ULTRAHIGH DENSITY VERTICAL NAND FLASH MEMORY AND METHOD OF MAKING THEREOF**
VERTIKALER FLOATING-GATE NAND-SPEICHER MIT ULTRAHOHER DICHTE UND VERFAHREN ZUR HERSTELLUNG DAVON
MÉMOIRE FLASH NAND VERTICALE ULTRA-HAUTE DENSITÉ À GRILLE FLOTTANTE ET SON PROCÉDÉ DE FABRICATION

(30) Priority: 20.08.2014 US 201414464385
(43) Date of publication of application: 28.06.2017
(73) Proprietor: SanDisk Technologies LLC, Plano, Texas 75024 (US)
(72) Inventor: MAKALA, Raghuveer, Milpitas, California 95035 (US); ZHANG, Yanli, Milpitas, California 95035 (US); LEE, Yao-Sheng, Milpitas, California 95035 (US); KANAKAMEDALA, Senaka, Milpitas, California 95035 (US); SHARANGPANI, Rahul, Milpitas, California 95035 (US); MATAMIS, George, Milpitas, California 95035 (US); ALSMEIER, Johann, Milpitas, California 95035 (US); SHIMABUKURO, Seiji, Milpitas, California 95035 (US); MIZUNO, Genta, Milpitas, California 95035 (US); TAKEGUCHI, Naoki, Milpitas, California 95035 (US)
(74) Representative: Dehns
(86) International application number: PCT/US2015/045205
(87) International publication number: WO 2016/028621

(56) References cited:
- US-A1- 2012 001 247
- US-A1- 2014 225 181
- WANG S-Q: "BARRIERS AGAINST COPPER DIFFUSION INTO SILICON AND DRIFT THROUGH SILICON DIOXIDE", MRS BULLETIN, PITTSBURGH, US, August 1994 (1994-08), pages 30-40, XP000578811,

## Description

### FIELD

The present disclosure relates generally to the field of semiconductor devices and specifically to three dimensional vertical NAND strings and other three dimensional devices and methods of making thereof.

### BACKGROUND

Three dimensional vertical NAND strings are disclosed in an article by T. Endoh, et. al., titled "Novel Ultra High Density Memory With A Stacked-Surrounding Gate Transistor (S-SGT) Structured Cell", IEDM Proc. (2001) 33-36.

US 2014/225181, over which the independent claims are characterized, discloses a three dimensional NAND device with semiconductor, metal, or silicide floating gates and a method of making thereof. The article by S-Q Wang published in MRS Bulletin, August 1994, pages 30 - 40, discloses barriers against copper diffusion into silicon and drift through silicon dioxide.

US 2012/001247 discloses an ultrahigh density vertical NAND memory device and a method of making thereof.

### SUMMARY

According to one aspect the present invention provides a method of making a monolithic three dimensional NAND string as claimed in claim 1.

In an embodiment the method further includes forming a plurality of first control gate layers in the respective clam shell shaped regions of the first barrier layer in the back side recesses, selectively recessing the first control gate layers and the first barrier layers in the back side recesses and forming a plurality of second control gate layers in the respective clam shell shaped regions of the blocking dielectric in the back side recesses.

In another embodiment the method further includes forming a second barrier layer over the first barrier layer in the back side opening and the back side recesses, the second barrier layer having clam shaped regions inside the clam shaped first barrier layer. The method also includes selectively removing the first and second barrier layers from the back side opening, then selectively, partially recessing the first barrier layer in the back side recesses to expose a portion of the clam shaped regions of the first barrier layer adjacent to the back side opening, and forming a plurality of control gate layers in the respective clam shell shaped regions of the first and second barrier layers in the back side recesses.

### BRIEF DESCRIPTION OF THE DRAWINGS

FIGs. 1A-1B are respectively side cross sectional and top cross sectional views of a NAND string of one embodiment. Figure 1A is a side cross sectional view of the device along line Y-Y' in Figure 1B, while Figure 1B is a side cross sectional view of the device along line X-X' in Figure 1A.
FIGs. 2A-2B are respectively side cross sectional and top cross sectional views of a NAND string of another embodiment. Figure 2A is a side cross sectional view of the device along line Y-Y' in Figure 2B, while Figure 2B is a side cross sectional view of the device along line X-X' in Figure 2A.
FIG. 3 is side cross sectional view of a NAND string of an embodiment with a U-shaped channel.
FIGs. 4A-4E, 5A-5E, 6A-6E, 7A-7E, 8A-8C and 9A-9E are side cross sectional views illustrating embodiments of methods of making the NAND strings illustrated in FIGs. 1-3.
FIG. 10 is a side cross sectional view of a NAND string of another embodiment.
FIGs. 11A-11D are side cross sectional views illustrating an embodiment of methods of making the NAND strings illustrated in FIG. 10.
FIGs. 12A-12B are respectively side cut away cross sectional and top cross sectional views of a NAND string of one embodiment.
FIGs. 13A-13E are side cross sectional views illustrating a method of making a NAND strings beyond the scope of the claims.
FIGs. 14A-14E are side cross sectional views illustrating a method of making a NAND strings beyond the scope of the claims.
FIGs. 15A-15E are side cross sectional views illustrating a method of making a NAND strings according to another embodiment.
FIGs. 16A-16E are side cross sectional views illustrating a method of making a NAND strings according beyond the scope of the claims.
FIGs. 17A-17E are side cross sectional views illustrating a method of making a NAND strings according beyond the scope of the claims.
FIGs. 18A-18E are side cross sectional views illustrating a method of making NAND strings according to another embodiment.
FIGs. 19A and 19B are side cross sectional views illustrating common defects in single step control gate fabrication processes.
FIGs. 20A-20D are side cross sectional views illustrating an embodiment of a method of making NAND strings according to another embodiment.

### DETAILED DESCRIPTION

The embodiments provide a monolithic, three dimensional array of memory devices, such as an array of vertical NAND strings having metal control gates, such as copper or other metal control gates. The NAND strings are vertically oriented, such that at least one memory cell is located over another memory cell. The array allows vertical scaling of NAND devices to provide a higher density of memory cells per unit area of silicon or other semiconductor material.

A monolithic three dimensional memory array is one in which multiple memory levels are formed above a single substrate, such as a semiconductor wafer, with no intervening substrates. The term "monolithic" means that layers of each level of the array are directly deposited on the layers of each underlying level of the array. In contrast, two dimensional arrays may be formed separately and then packaged together to form a non-monolithic memory device. For example, non-monolithic stacked memories have been constructed by forming memory levels on separate substrates and adhering the memory levels atop each other, as in Leedy, U.S. Pat. No. 5,915,167, titled "Three Dimensional Structure Memory." The substrates may be thinned or removed from the memory levels before bonding, but as the memory levels are initially formed over separate substrates, such memories are not true monolithic three dimensional memory arrays.

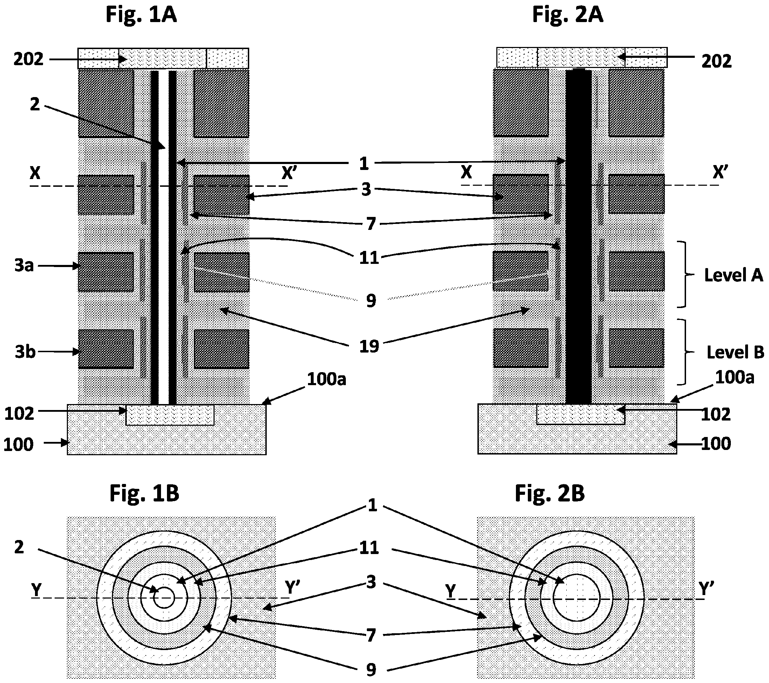

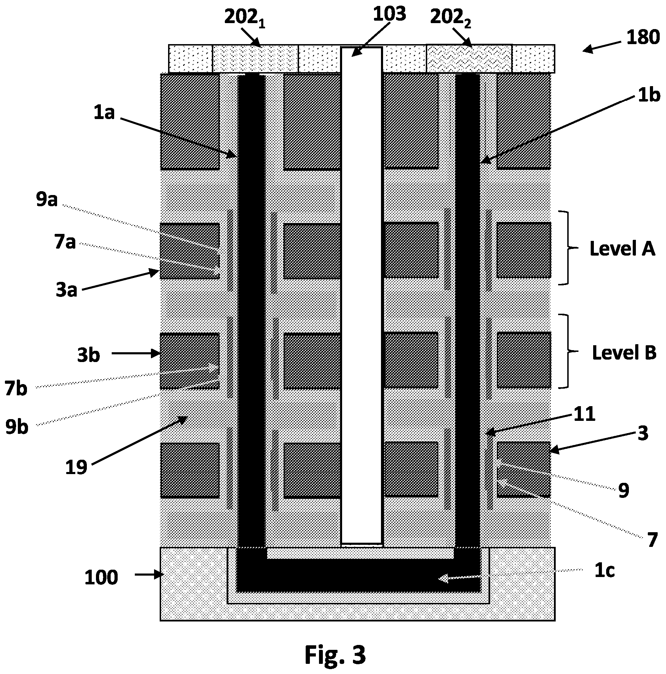

In some embodiments, the monolithic three dimensional NAND string 180 comprises a semiconductor channel 1 having at least one end portion extending substantially perpendicular to a major surface 100a of a substrate 100, as shown in Figures 1A and 2A. For example, the semiconductor channel 1 may have a pillar shape and the entire pillar-shaped semiconductor channel extends substantially perpendicularly to the major surface of the substrate 100, as shown in Figures 1A and 2A. In these embodiments, the source/drain electrodes of the device can include a lower electrode 102 provided below the semiconductor channel 1 and an upper electrode 202 formed over the semiconductor channel 1, as shown in Figures 1A and 2A. Alternatively, the semiconductor channel 1 may have a U-shaped pipe shape, as shown in Figure 3. The two wing portions 1a and 1b of the U-shaped pipe shape semiconductor channel may extend substantially perpendicular to the major surface 100a of the substrate 100, and a connecting portion 1c of the U-shaped pipe shape semiconductor channel 1 connects the two wing portions 1a, 1b extends substantially parallel to the major surface 100a of the substrate 100. In these embodiments, one of the source or drain electrodes 202₁ contacts the first wing portion of the semiconductor channel from above, and another one of a source or drain electrodes 202₂ contacts the second wing portion of the semiconductor channel 1 from above. An optional body contact electrode (not shown) may be disposed in the substrate 100 to provide body contact to the connecting portion of the semiconductor channel 1 from below. The NAND string's select or access transistors are not shown in Figures 1-3 for clarity.

In some embodiments, the semiconductor channel 1 may be a filled feature, as shown in Figures 2A-2B and 3. In some other embodiments, the semiconductor channel 1 may be hollow, for example a hollow cylinder filled with an insulating fill material 2, as shown in Figures 1A-1B. In these embodiments, an insulating fill material 2 may be formed to fill the hollow part surrounded by the semiconductor channel 1. The U-shaped pipe shape semiconductor channel 1 shown in Figure 3 may alternatively be a hollow cylinder filled with an insulating fill material 2, shown in Figures 1A-1B.

The substrate 100 can be any semiconducting substrate known in the art, such as monocrystalline silicon, IV-IV compounds such as silicon-germanium or silicon-germanium-carbon, III-V compounds, II-VI compounds, epitaxial layers over such substrates, or any other semiconducting or non-semiconducting material, such as silicon oxide, glass, plastic, metal or ceramic substrate. The substrate 100 may include integrated circuits fabricated thereon, such as driver circuits for a memory device.

Any suitable semiconductor materials can be used for semiconductor channel 1, for example silicon, germanium, silicon germanium, or other compound semiconductor materials, such as III-V, II-VI, or conductive or semiconductive oxides, etc. The semiconductor material may be amorphous, polycrystalline or single crystal. The semiconductor channel material may be formed by any suitable deposition methods. For example, in one embodiment, the semiconductor channel material is deposited by low pressure chemical vapor deposition (LPCVD). In some other embodiments, the semiconductor channel material may be a recrystallized polycrystalline semiconductor material formed by recrystallizing an initially deposited amorphous semiconductor material.

The insulating fill material 2 may comprise any electrically insulating material, such as silicon oxide, silicon nitride, silicon oxynitride, or other high-k insulating materials.

The monolithic three dimensional NAND string further comprise a plurality of control gate electrodes 3, as shown in Figures 1A-1B, 2A-2B, and 3. The control gate electrodes 3 may comprise a portion having a strip shape extending substantially parallel to the major surface 100a of the substrate 100. The plurality of control gate electrodes 3 comprise at least a first control gate electrode 3a located in a first device level (e.g., device level A) and a second control gate electrode 3b located in a second device level (e.g., device level B) located over the major surface 100a of the substrate 100 and below the device level A. The control gate material may comprise any one or more suitable conductive or semiconductor control gate material known in the art, such as doped polysilicon, tungsten, copper, aluminum, tantalum, titanium, cobalt, titanium nitride or alloys thereof.

A blocking dielectric 7 is located adjacent to the control gate(s) 3 and may surround the control gate 3. The blocking dielectric 7 may comprise a layer having plurality of blocking dielectric segments located in contact with a respective one of the plurality of control gate electrodes 3, for example a first dielectric segment 7a located in device level A and a second dielectric segment 7b located in device level B are in contact with control electrodes 3a and 3b, respectively, as shown in Figure 3.

The monolithic three dimensional NAND string also comprise a plurality of discrete charge storage regions or segments 9 located between the blocking dielectric 7 and the channel 1. Similarly, the plurality of discrete charge storage regions 9 comprise at least a first discrete charge storage region 9a located in the device level A and a second discrete charge storage region 9b located in the device level B, as shown in Figure 3.

The discrete charge storage regions 9 may comprise a plurality of vertically spaced apart, conductive (e.g., metal such as tungsten, molybdenum, tantalum, titanium, platinum, ruthenium, and alloys thereof, or a metal silicide such as tungsten silicide, molybdenum silicide, tantalum silicide, titanium silicide, nickel silicide, cobalt silicide, or a combination thereof), or semiconductor (e.g., polysilicon) floating gates.

The tunnel dielectric 11 of the monolithic three dimensional NAND string is located between each one of the plurality of the discrete charge storage regions 9 and the semiconductor channel 1.

The blocking dielectric 7 and the tunnel dielectric 11 may be independently selected from any one or more same or different electrically insulating materials, such as silicon oxide, silicon nitride, silicon oxynitride, or other insulating materials. The blocking dielectric 7 and/or the tunnel dielectric 11 may include multiple layers of silicon oxide, silicon nitride and/or silicon oxynitride (e.g., ONO layers).

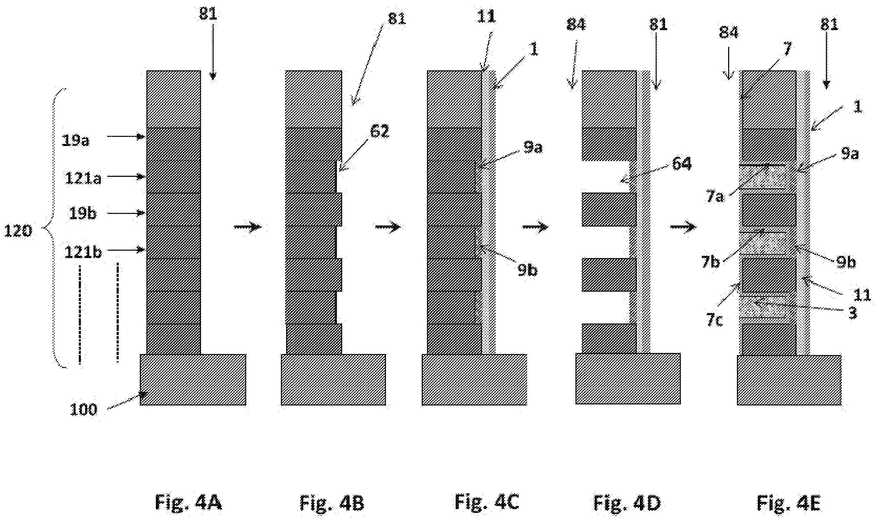

Figures 4A-4E illustrate a method of making a NAND string according to a first embodiment.

Referring to Figure 4A, a stack 120 of alternating layers 19 (19a, 19b etc.) and 121 (121a, 121b, etc.) are formed over the major surface of the substrate 100. Layers 19, 121 may be deposited over the substrate by any suitable deposition method, such as sputtering, CVD, PECVD, MBE, etc. The layers 19, 121 may be 6 to 100 nm thick.

In this embodiment, the first layers 19 comprise an electrically insulating material. Any suitable insulating material may be used, such as silicon oxide, silicon nitride, silicon oxynitride, a high-k dielectric (e.g., aluminum oxide, hafnium oxide, etc. or an organic insulating material). The second layers 121 comprise a sacrificial material, such a semiconductor material. For example, layers 121 may comprise silicon, such as amorphous silicon or polysilicon, or another semiconductor material, such as a group IV semiconductor, including silicon-germanium and germanium. Layers 121 may comprise intrinsic or undoped (if the as-deposited material inherently has a low p-type or n-type conductivity) semiconductor material, such as intrinsic or undoped polysilicon or amorphous silicon. However, p-type or n-type doped semiconductor materials, such as lightly or heavily doped materials may also be used if desired. The term heavily doped includes semiconductor materials doped n-type or p-type to a concentration of above 10¹⁸ cm⁻³. In contrast, lightly doped semiconductor materials have a doping concentration below 10¹⁸ cm⁻³ and intrinsic semiconductor materials have a doping concentration below 10¹⁵ cm⁻³.

The deposition of layers 19, 121, is followed by etching the stack 120 to form at least one a front side opening 81 in the stack 120. An array of a front side openings 81 (e.g., memory holes) may be formed in locations where vertical channels of NAND strings will be subsequently formed. The openings 81 may be formed by photolithography and etching.

Next, in an optional step as shown in Figure 4B, the second material 121 is selectively etched compared to the first material 19 to form front side recesses 62 in the second material 121 (i.e., layers 121a, 121b, etc). The recesses 62 may be formed by selective, isotropic wet or dry etching which selectively etches the second material 121 compared to the first material 19. The depth of each recess 62 may be 3 to 20 nm. As will be described below, this step may be omitted if desired.

As shown in Figure 4C, a plurality of discrete semiconductor, metal or silicide charge storage regions 9 are selectively formed on portions of the second material layers 121 exposed in the front side opening 81. The charge storage regions 9 comprise a plurality of charge storage segments or regions (e.g., 9a and 9b) located on the exposed edges of the second material 121 in the front side recesses 62.

In one embodiment, the charge storage regions 9 are selectively formed by selective growth of the regions on the exposed edges of the semiconductor second material layers 121 but not on the exposed insulating first material layers 19. Any suitable selective growth methods may be used to form the charge storage regions 9, such as chemical vapor deposition.

In one aspect of the selective growth embodiment, charge storage regions 9 comprise doped polysilicon regions which are selectively grown by CVD on the portions of the undoped or intrinsic second material layers 121 (e.g., undoped or intrinsic semiconductor having a polycrystalline or amorphous structure, such as polysilicon, amorphous silicon, silicon germanium or germanium) exposed in the front side opening 81. For example, the doped polysilicon regions 9 may comprise boron doped, p-type polysilicon regions (e.g., lightly or heavily doped) which are selectively, epitaxially grown on polysilicon layer 121 edges exposed in the front side openings 81. The doped polysilicon regions 9 are not grown on portions of the first material layers 19 (e.g., silicon oxide) exposed in the front side opening 81.

Any suitable silicon selective epitaxial growth (SEG) conditions may be used to form regions 9. For example, a chemical vapor deposition (CVD) SEG process which combines a silicon source gas and a silicon growth inhibitor gas which inhibits silicon growth on the oxide layers 19 may be used. Exemplary silicon source gases include silane and chloro-silanes (e.g., SiH₄, SiH₂Cl₂, and/or SiHCl₃). Exemplary inhibitor gases which inhibit silicon growth on SiO₂ include HCl and/or Cl₂. H₂ may be used as a carrier gas while B₂H₆, AsH₃ and/or PH₃ gases may be added to introduce dopants to the silicon regions 9. Any suitable SEG temperatures and pressures may be used, such as a temperature of 500 to 800C and a pressure of 10 mTorr to 100 Torr (i.e., LPCVD). Similar process conditions may be used to form germanium or silicon-germanium charge storage regions 9, where germane (GeH₄) is substituted for silane or provided in addition to silane, at lower temperatures (e.g., 340 to 380C) and pressure of about 10 mTorr -5 Torr, such as about 1 Torr.

If it is desirable to form a metal silicide floating gates 9a, 9b rather than polysilicon floating gates 9a, 9b, then a thin silicide forming metal layer, such as titanium, cobalt or nickel is formed by any suitable method, such as ALD or sputtering, over the polysilicon floating gates 9a, 9b shown in Figure 4C. After a silicidation anneal, the floating gates 9a, 9b are converted to a metal silicide (e.g., titanium, cobalt, nickel, etc. silicide) by the reaction of the metal and the polysilicon. Unreacted portions of the metal layer which remain over portions of insulating material 19 are then selectively etched.

In another aspect of the selective growth embodiment, charge storage regions 9 comprise selectively grown metal or silicide charge storage regions, such as on the portions of the second material layers exposed in the front side opening. Any metal (i.e., pure metal or conductive metal alloy) or metal silicide which may be selectively grown on exposed semiconductor layer 121 in the opening 81 may be used. For example, the charge storage regions 9 may comprise selectively grown tungsten, molybdenum or tantalum regions that are selectively grown on the semiconductor material (e.g., silicon) 121 but not on insulating material (e.g., silicon oxide) 19 from a metal halide source gas (e.g., tungsten hexafluoride) in a CVD process.

Selective deposition of refractory metals, such as W, Mo or Ta, on silicon may be performed by metal halide source gas reduction by SiH₄, where a ratio of SiH₄ to metal halide is less than one. For example, as disclosed in U.S. patent numbers 5,084,417 and 5,807,788, in the selective CVD process, the metal halide source gas may comprise WF₆, MoF₆ or TaCl₅ and the deposition temperature and pressure may range from 370 to 550C and 100 to 500 mTorr, respectively. The ratio of the SiH₄/metal halide flow rates may range between 0.4 and 0.6.

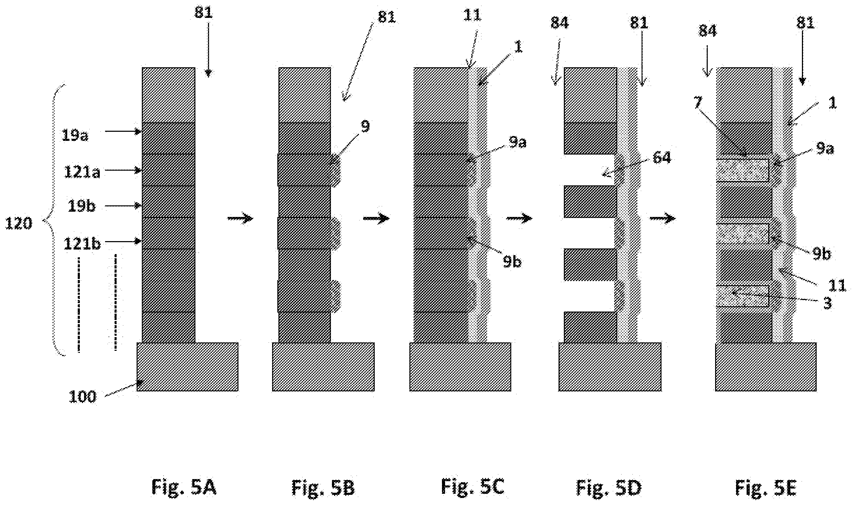

If the front side recesses 62 are present, then the regions 9 may be selectively grown in the front side recesses 62 until their edges are about even with the edges of the insulating material 19 such that they form a relatively straight sidewall of the front side opening 81 (e.g., as much as a timed selective growth permits). Alternatively, the selective growth of regions 9 is terminated before regions 9 completely fill the recesses 62. Thus, regions 9 may partially fill recesses 62 and may remain horizontally recessed in the opening 81 compared to insulating material layers 19. Alternatively, the selective growth of regions 9 is terminated after regions 9 completely fill the recesses 62 such that the regions 9 protrude horizontally into the front side opening 81 past layers 19, as shown in Figure 5C.

In another embodiment, the regions 9 are selectively formed by doping of the semiconductor layers 121 exposed in the front side opening 81. For example, when layers 121 comprise intrinsic or undoped semiconductor layers, a timed gas phase diffusion doping may be carried out to dope the edge portions 9 of layers 121 facing the opening 81 by providing a doping gas through the opening 81. The doping is terminated before the entire volume of layers 121 are doped, such that portions of layers 121 located behind regions 9 and facing away from the opening 81 remain undoped. For example, for Group IV semiconductor material (e.g., silicon) layers 121, the doping gas may comprise a boron containing gas, such as diborane, to form p-type doped regions 9, or a phosphorus or arsenic containing gas, such as phosphine or arsene, to form n-type doped regions 9.

In the next step shown in Figure 4C, a tunnel dielectric layer 11 is deposited over the charge storage regions 9a, 9b and the insulating first material layers 19 between the charge storage regions in the front side opening 81. Then, the channel 1 is formed by depositing channel material 1, such as a lightly doped or intrinsic polysilicon over the tunnel dielectric layer 11 in the front side opening 81. If desired, a high temperature anneal may be performed after forming the channel.

As discussed above, the entire opening 81 may be filled to form the device illustrated in Figures 2A and 2B. Alternatively, a layer of channel material may first be deposited in the opening 81 followed by deposition of an insulating fill material 2 to form the device illustrated in Figures 1A and 1B. If desired, the channel 1 may be U-shaped as illustrated in Figure 3.

The channel 1 may be formed by filling the front side opening 81 with a lightly doped semiconductor material (e.g., polysilicon) and then etched back from the top to form the pillar shaped (or U-shaped) channel 1 in the opening 81. In the embodiment of Figure 3, the space between the wings of the U-channel 1 is filled with a gap fill insulating layer 103, such as silicon oxide or another material. Layer 103 may be formed by etching the stack 120 to form a rail shaped cut, followed by depositing an oxide layer followed by etch back or chemical mechanical polishing to form a planar top surface exposing the top surfaces of the channels 1. The channels are then connected to source and drain electrodes 102, 202 as shown in Figures 1-3, the select gate electrodes (not shown for clarity) are connected to select gate contacts and the control gate electrodes 3 are connected to word line contacts as known in the art.

In the next step shown in Figure 4D, the stack 120 is patterned to form one or more back side openings 84 in the stack. The back side opening(s) 84 may be formed by photolithography and anisotropic etching of the stack. In an embodiment, the opening(s) 84 have a slit shape.

Then, at least a portion of the second material layers 121 are removed through the back side opening 84 to form back side recesses 64 between the first material layers 19. For example, layers 121 may be removed completely by selective wet etching using a liquid etching medium which selectively etches the material of layers 121 compared to the materials of layers 19 and regions 9. For example, if layers 121 comprise undoped or intrinsic polysilicon, layers 19 comprise silicon oxide and regions 9 comprise doped polysilicon, silicide or metal, then an undoped polysilicon selective etch may be used which stops on doped polysilicon (e.g., p-type polysilicon) regions 9 which act as an etch stop. Alternatively, the selective etch may be a timed etch which is timed to remove only a portion of the sacrificial second material layers 121 through the back side opening 84. In this case, a remaining portion of the second material layers 121 rather than regions 9 remain exposed in the back side recesses 64.

Then, as shown in Figure 4E, the blocking dielectric layer 7 (also known as an inter-poly dielectric, IPD) is then formed in the back side recesses 64 through the back side opening 84 such that the blocking dielectric coats the sides of the back side recesses 64 and the back side of layers 19 exposed in the back side opening 84. The blocking dielectric layer 7 may comprise a silicon oxide layer deposited by conformal atomic layer deposition (ALD) or chemical vapor deposition (CVD). Other high-k dielectric materials, such as hafnium oxide, or multi-layer dielectrics (e.g., ONO) may be used instead or in addition to silicon oxide. Optionally, an insulating capping layer (e.g., silicon nitride) may be deposited into the openings before the blocking dielectric 7 and may comprise a back portion of a multi-layer blocking dielectric. The blocking dielectric 7 may have a thickness of 6 to 20 nm. An optional anneal, such as a rapid thermal anneal, may be conducted after the blocking dielectric formation.

The blocking dielectric layer 7 comprises a plurality of clam-shaped blocking dielectric segments 7a, 7b in the back side recesses 64 connected to each other by vertical portions 7c of the blocking dielectric layer 7 located on the exposed edges of the first material layers 19 in the back side opening 84. As used herein a "clam" shape is a side cross sectional shape configured similar to an English letter "C". A clam shape has two segments which extend substantially parallel to each other and to the major surface 100a of the substrate 100. The two segments are connected to each other by a third segment which extends substantially perpendicular to the first two segments and the surface 100a. Each of the three segments may have a straight shape (e.g., a rectangle side cross sectional shape) or a somewhat curved shape (e.g., rising and falling with the curvature of the underlying topography). The term substantially parallel includes exactly parallel segments as well as segments which deviate by 20 degrees or less from the exact parallel configuration. The term substantially perpendicular includes exactly perpendicular segments as well as segments which deviate by 20 degrees or less from the exact perpendicular configuration. The clam shape contains an opening bounded by the three segments and having a fourth side open.

The opening in the clam shaped blocking dielectric segments is then filled by a control gate 3 material. As described above, the control gate material may comprise a metal, such as tungsten or a heavily doped semiconductor, such as polysilicon. The control gate material may be deposited by CVD and fills the remaining volume of the back side recesses 64 inside the clam shaped blocking dielectric 7 segments and the entire back side opening 84. The deposition of the control gate material is followed by etching the control gate material to remove it from the back side opening 84 using anisotropic etching, while leaving the control gate material inside the back side recesses 64 in the clam shaped blocking dielectric 7 segments. The remaining control gate material inside the back side recesses 64 forms the control gates 3 of the vertical NAND string.

Figures 5A-5E illustrate a method of making a vertical NAND string according to another embodiment. The steps resulting in the structure shown in Figure 5A are the same as described above with respect to Figure 4A. However, in this embodiment, the front side recesses 62 shown in Figure 4B are omitted. In this embodiment, the charge storage regions 9 are selectively grown on exposed edges of the sacrificial layers 121 exposed in the front side opening 81. Thus, as shown in Figure 5B, the charge storage regions 9 protrude horizontally (i.e., parallel to the major surface 100a of the substrate 100) into the front side opening 81.

The process then proceeds in the same manner as described above with respect to Figures 4C-4E. Thus, the tunnel dielectric layer 11 and the channel 1 are formed in the front side opening 81, as shown in Figure 5C. The sacrificial layers 121 are at least partially removed through the back side opening 84, as shown in Figure 5D. Finally, the blocking dielectric 7 and the control gates 3 are formed through the back side opening as shown in Figure 5E.

Thus, as shown in Figures 5D-5E, the plurality of vertically spaced apart charge storage regions 9 protrude into the tunnel dielectric 11 such that the tunnel dielectric 11 and the semiconductor channel 1 curve around the plurality of vertically spaced apart charge storage regions 9. Thus, the tunnel dielectric 11 of this embodiment has a curved rather than a straight sidewall.

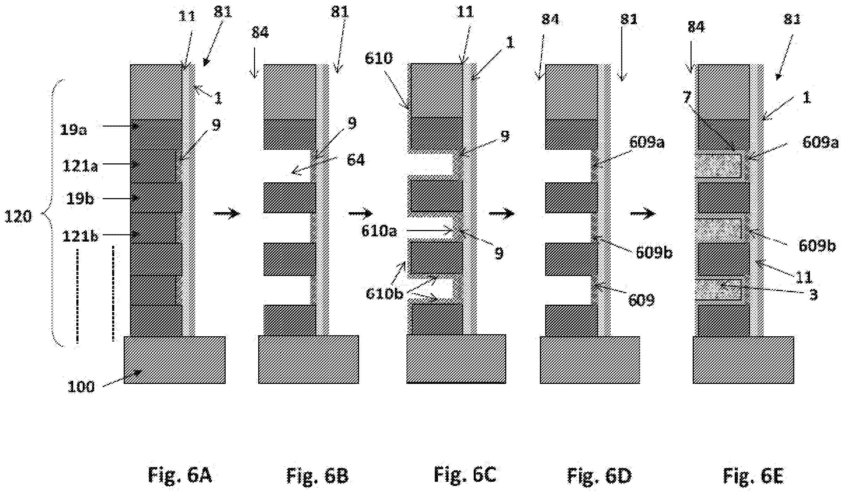

Figures 6A-6E illustrate a method of making a vertical NAND string according to another embodiment using a back side silicide charge storage region 9 formation. The steps resulting in the structure shown in Figure 6A are the same as described above with respect to Figure 4A-4C or 5A-5C. Thus, the initial process steps may be the same as the steps shown in Figures 4A-4C or 5A-5C and described above, to form either recessed or protruding semiconductor charge storage regions 9, tunnel dielectric 11 and channel 1 in the front side opening 81. In other words, Figure 6A illustrates an in-process device at the same stage as either Figure 4C or 5C.

Then, as shown in Figure 6B, the back side opening 84 and the back side recesses 64 are formed, using steps similar to those described above with respect to Figures 4D or 5D. The entire sacrificial material layers 121 are removed to expose the silicon (e.g., doped polysilicon) charge storage regions 9 in the back side recesses 64, as shown in Figure 6B.

Then, after the second material layers 121 are removed to expose the polysilicon charge storage regions 9 in the back side recesses 64, a metal layer 610 is formed through the back side opening 84 in the back side recesses 64, such that portions 610a of the metal layer 610 are in contact with the polysilicon charge storage regions 9, as shown in Figure 6C. The metal layer 610 may be formed using CVD or other deposition methods. The metal layer 610 may comprise any metal layer which may form a silicide when it reacts with silicon. For example, the metal layer may comprise tungsten, molybdenum, tantalum, titanium, nickel, cobalt, etc.

Following the metal layer 610 deposition step, the structure is annealed using any suitable silicidation anneal parameters to react portions 610a of the metal layer 610 with the silicon charge storage regions 9 to convert the silicon (e.g., polysilicon) charge storage regions to silicide charge storage regions 609 (e.g., 609a, 609b, etc.). The silicide charge storage regions may comprise tungsten silicide, molybdenum silicide, tantalum silicide, titanium silicide, nickel silicide, cobalt silicide, etc.

In an embodiment, the entire silicon charge storage regions 9 are converted to silicide charge storage regions 609 so that no unreacted silicon remains in the charge storage regions. Alternatively, only part of the silicon charge storage regions are converted to silicide charge storage regions 609, such that the charge storage regions comprise inner silicide portions adjacent to the blocking dielectric 7 and outer silicon portions adjacent to the tunnel dielectric 11. Then, as shown in Figure 6D, the remaining unreacted portions 610b of the metal layer 610 are removed by any suitable selective wet etching without removing the silicide charge storage regions 609, as is typical in a silicide formation process.

The process then proceeds in the same manner as described above with respect to Figures 4E or 5E, where the blocking dielectric 7 and the control gates 3 are formed through the back side opening 84 as shown in Figure 6E.

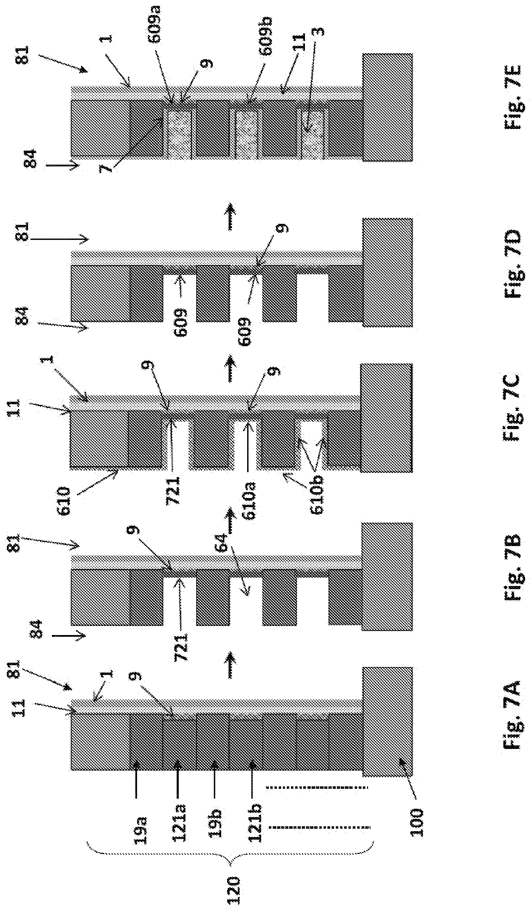

Figures 7A-7E illustrate a method of making a vertical NAND string according to an alternative embodiment using a back side silicide formation. In this embodiment, portions 721 of the sacrificial semiconductor layers 121, such as polysilicon or amorphous silicon layer portions 721, remain in the back side recesses 64. The charge storage regions 9 may comprise semiconductor, metal or silicide regions in this embodiment.

The steps resulting in the structure shown in Figure 7A are the same as described above with respect to Figure 4A-4C or 5A-5C or 6A. Then, as shown in Figure 6B, the back side opening 84 and the back side recesses 64 are formed, using steps similar to those described above with respect to Figures 4D or 5D. Only parts of the entire sacrificial semiconductor material layers 121 are removed to leave portions 721 of the sacrificial semiconductor layers 121 exposed in the back side recesses 64, as shown in Figure 7B.

Then, as shown in Figure 7C, a metal layer 610 is formed through the back side opening 84 in the back side recesses 64, such that portions 610a of the metal layer 610 are in contact with the remaining portions 721 of the sacrificial semiconductor layers.

Following the metal layer 610 deposition step, the structure is annealed using any suitable silicidation anneal parameters to react portions 610a of the metal layer 610 with the portions 721 of the sacrificial semiconductor layers to convert the portions 721 of the sacrificial semiconductor layers to silicide storage regions 609 (e.g., 609a, 609b).

If the charge storage regions 9 comprise silicon (e.g., polysilicon), then the silicon charge storage regions 9 may also converted to silicide charge storage regions 609 together with portions 721 so that no unreacted silicon remains in the charge storage regions, similar to the structure shown in Figure 6D.

Alternatively, as shown in Figure 7D, only the portions 721 of the sacrificial semiconductor layers are converted to silicide charge storage regions 609, leaving initial charge storage regions 9 unconverted. This forms composite charge storage regions which comprise inner silicide portions 609 adjacent to the blocking dielectric 7 and outer silicon, silicide or metal portions 9 adjacent to the tunnel dielectric 11, as shown in Figure 7D. Then, the remaining unreacted portions 610b of the metal layer 610 are removed by any suitable selective wet etching without removing the silicide charge storage regions 609, as is typical in a silicide formation process. The process then proceeds in the same manner as described above with respect to Figures 4E or 5E, where the blocking dielectric 7 and the control gates 3 are formed through the back side opening 84 as shown in Figure 7E.

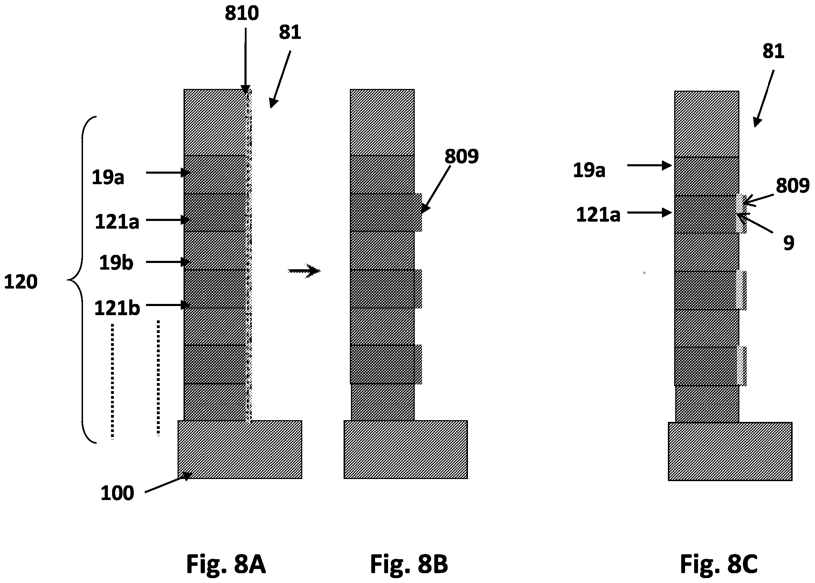

Figures 8A-8B illustrate a method of making a vertical NAND string according to an alternative embodiment using a front side silicide formation. The steps resulting in the structure shown in Figure 8A are the same as described above with respect to Figures 4A-4C or 5A-5C or 6A, except for the deposition of the metal layer 810.

Thus, as shown in Figure 8A, the stack 120 is formed and then patterned to form the front side opening 81. The charge storage regions 9 may be omitted if the sacrificial layers 121 comprise silicon (e.g., doped or undoped polysilicon or amorphous silicon), as shown in Figure 8A. Alternatively, silicon (e.g., doped polysilicon) charge storage regions 9 may be selectively formed on the sacrificial layers 121 in the front side recesses 62, as shown in Figure 4C, or protruding into the front side opening 81, as shown in Figure 5C.

Then, a silicide forming metal layer 810 is formed in the front side opening 81. Layer 810 may comprise the same material as that described for layer 610 above. The metal layer 810 contacts the edges of the silicon sacrificial layers 121 if the charge storage regions 9 are not present or the metal layer 810 contacts the charge storage regions 9 if these regions are present in the front side opening 81.

The structure is then subjected to a silicidation anneal to react the metal layer 810 with the silicon regions exposed in the front side opening 81, as shown in Figure 8B. For example, if the charge storage regions 9 are omitted as shown in Figure 8A, then the metal layer 810 is reacted with the edge portions of the second (sacrificial silicon) material layers 121 exposed in the front side opening 81 to selectively form discrete silicide charge storage regions 809.

If the silicon charge storage regions 9 are present, then the metal layer 810 is reacted with the silicon charge storage regions 9 exposed in the front side opening 81 to convert all or parts of the silicon charge storage regions 9 to discrete silicide charge storage regions 809. If only the front parts of the silicon charge storage regions 9 are converted to silicide regions 809, then composite charge storage regions are formed. The composite charge storage regions comprise outer silicide portions 809 adjacent to the tunnel dielectric 11 and inner silicon portions 9 adjacent to the blocking dielectric 7, as shown in Figure 8C.

Then, the remaining unreacted portions of the metal layer 810 are removed by any suitable selective wet etching without removing the discrete silicide charge storage regions 809, as is typical in a silicide formation process. The process then proceeds in the same manner as described above with respect to Figures 4D-4E or 5D-5E, where the sacrificial layers 121 are removed through the back side opening 84 and then the blocking dielectric 7 and the control gates 3 are formed through the back side opening 84.

In another embodiment, the plurality of discrete semiconductor, metal or silicide charge storage regions 9, 609, 809 are nitrided to form nitrided charge storage regions. For example, any of the charge storage regions described above and shown in Figures 4, 5, 6, 7 or 8 may be annealed in a nitrogen containing ambient, such nitrogen or NO radical ambient at an elevated temperature, to convert at least a portion of the charge storage region to a nitride material.

For example, the edge or outer portion of the charge storage regions exposed in the front side opening 81 may be converted to a nitride material prior to forming the tunnel dielectric layer 11, while the inner portion of the charge storage regions facing the blocking dielectric 7 may remain a semiconductor, metal or silicide material that is not nitrided. This results in a composite charge storage region. Alternatively, the entire volume of the charge storage material may be nitrided to convert the entire charge storage material to a nitride material.

For example, when the charge storage regions 9 comprise silicon (e.g., polysilicon), the nitridation forms a silicon nitride charge storage region. When the charge storage regions 9 comprise a metal (e.g., tungsten, tantalum, titanium, etc.), the nitridation forms a metal nitride (e.g., tungsten nitride, tantalum nitride, titanium nitride, etc.) charge storage region. Thus, the plurality of vertically spaced apart charge storage regions 9 in this embodiment comprise a nitrided metal.

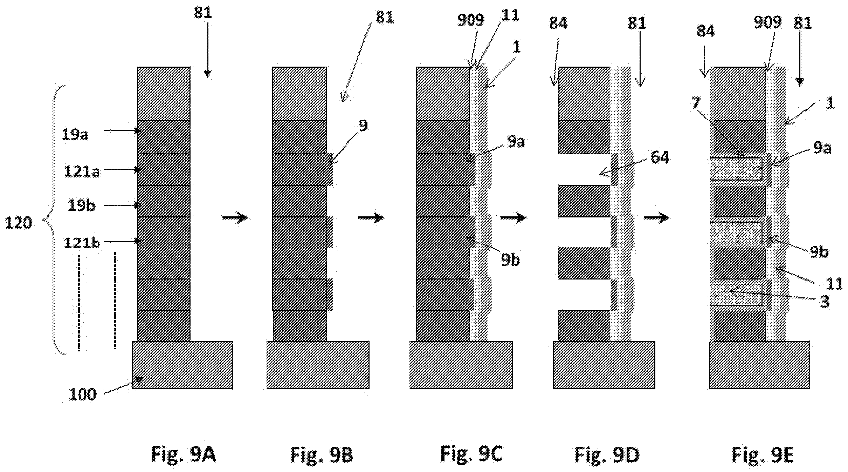

Figures 9A-9E illustrate a method of making a vertical NAND string with a hybrid charge storage structure according to an alternative embodiment. In this embodiment, a silicon nitride charge storage layer 909 is provided in the front side opening 81 in contact with the plurality of discrete semiconductor, metal or silicide charge storage regions 9, 609, 809 described above to form a hybrid charge storage structure. Any of the charge storage regions described above and shown in Figures 4, 5, 6, 7 or 8 may be combined with the silicon nitride charge storage layer 909 to form the hybrid charge storage structure.

For example, as shown in Figures 9A and 9B, the structure described above with respect to Figures 5A and 5B having the metal or semiconductor charge storage regions 9 protruding into the front side opening 81 is formed. Then, the silicon nitride layer 909 is formed in the front side opening 81 in contact with the charge storage regions 9, as shown in Figure 9C. While silicon nitride may be used a material for layer 909, other continuous dielectric (i.e., electrically insulating) materials, such as silicon oxynitride, may be used instead or in addition to silicon nitride. Thus, a continuous dielectric charge storage layer 909 is located in contact with the plurality of vertically spaced apart charge storage regions 9.

The process then proceeds in the same manner as described above with respect to Figures 4D-4E or 5D-5E where the sacrificial layers 121 are removed through the back side opening 84 and then the blocking dielectric 7 and the control gates 3 are formed through the back side opening 84. If desired, at least a part of the charge storage regions may be converted to a silicide using the back side silicidation process described above with respect to Figures 6D-6E or 7D-7E. Alternatively, at least a part of the metal or semiconductor charge storage regions may be converted to a silicide or a nitride using the front side silicidation process (as shown in Figures 8A-8C) or front side nitridation process described above.

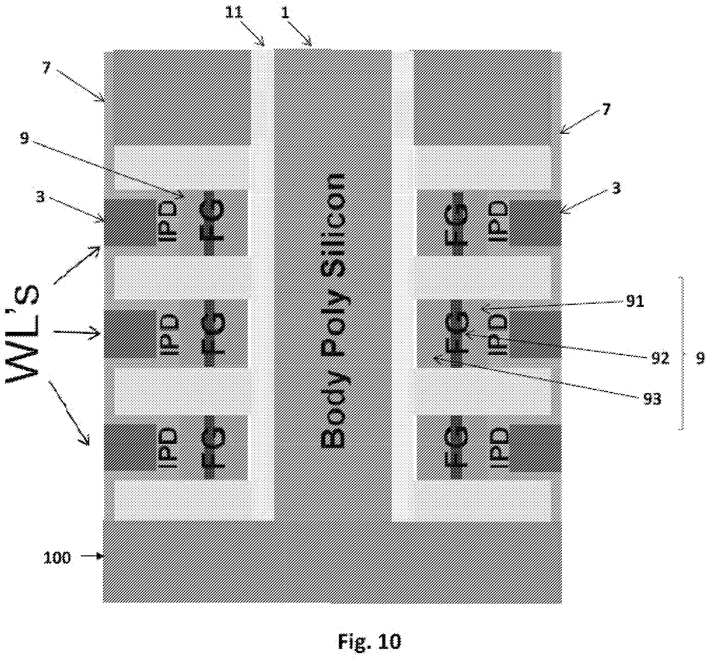

Figure 10 is a side cross sectional view of a NAND string of another embodiment. In this embodiment, each charge storage region 9 is floating gate made of three layers or regions 91, 92, 93. In an embodiment, the first layer 91 is polysilicon. The first layer 91 may be doped or undoped (i.e., intrinsic). The second layer 92 may be a silicide, such as tungsten silicide, molybdenum silicide, tantalum silicide, cobalt silicide, titanium silicide, nickel silicide or any other suitable silicide. In an embodiment, the third layer 93 is polysilicon. The third layer 93 may be doped or undoped, similar to the first layer 91. Further, the first and third layers 91 and 93 need not be the same. For example, the first layer 91 may be a doped polysilicon layer while the third layer 93 may be an undoped polysilicon layer. Alternatively, the first layer 91 may be an undoped polysilicon layer while the third layer 93 may be a doped polysilicon layer.

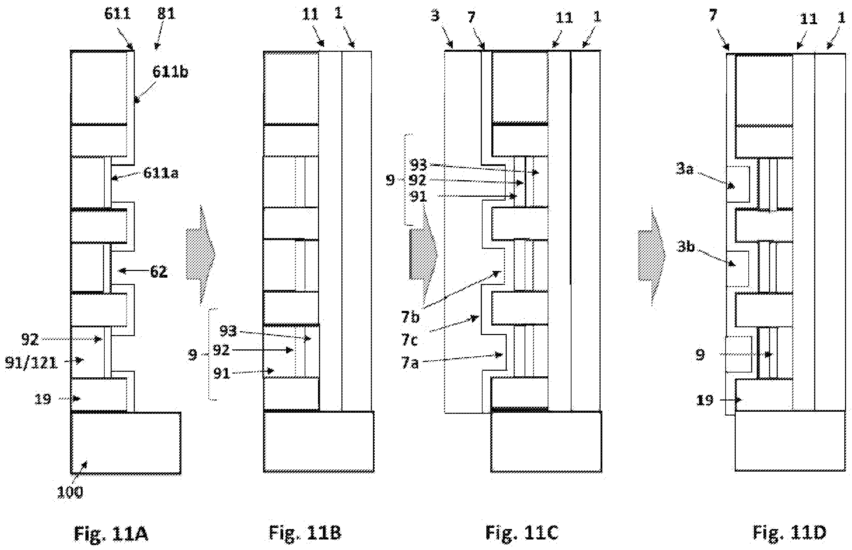

One embodiment method of making the NAND string will now be described with respect to Figures 4A, 4E and 11A-11D. As in previous embodiments, a stack 120 of alternating layers 19 and 121 may be deposited over the substrate 100 by any suitable method, such as sputtering, CVD, PECVD, MBE, etc as illustrated in Figure 4A. The deposition of layers 19, 121, is followed by etching the stack 120 to form at least one a front side opening 81 in the stack 120. As illustrated in Figure 4B, the second material 121 is selectively etched compared to the first material 19 to form front side recesses 62 in the second material 121. The recesses 62 may be formed by selective, isotropic wet or dry etching which selectively etches the second material 121 compared to the first material 19. In an embodiment, the second material 121 is polysilicon. The remaining portion of the second material 121 forms the first layer 91 of three layer 91, 92, 93 charge storage region 9 illustrated in Figure 10.

After the front side recesses 62 are formed in the second material 121, a metal layer 611 is formed through the front side opening 81 such that portions 611a of the metal layer 611 are in contact with the edge portions of the polysilicon charge storage region layers 91/121 exposed in the front side recesses 62, as shown in Figure 11A. The remaining portions 611b of layer 611 contact the exposed edges of layers 19 in opening 81. The metal layer 611 may be formed using CVD or other deposition methods. The metal layer 611 may comprise any metal layer which may form a silicide when it reacts with silicon. For example, the metal layer may comprise tungsten, molybdenum, tantalum, titanium, nickel, cobalt, etc.

Following the metal layer 611 deposition step, the structure is annealed using any suitable silicidation anneal parameters to react portions 611a of the metal layer 611 with the silicon charge storage regions 91 to convert a portion of the silicon (e.g., polysilicon) charge storage regions 91 to silicide charge storage regions 92. The silicide charge storage regions 92 may comprise tungsten silicide, molybdenum silicide, tantalum silicide, titanium silicide, nickel silicide, cobalt silicide, etc.

Next, the remaining unreacted portions 611b of the metal layer 611 located adjacent to the layers of first material 19 are removed by any suitable selective wet etching method without removing the silicide charge storage regions 92, as is typical in a silicide formation process.

As shown in Figure 11B, the rest of the recess 62 is filled with the third layer 93 of material making up the charge storage regions 9 of the present embodiment. Layer 93 comprises a polysilicon layer which may be deposited conformally on the silicide regions 92 through the opening 81 and followed by an anisotropic etch to remove portions of layer 93 exposed in the opening 81. Portions of layer 93 formed in the recesses 62 remain after the anisotropic etch. Thus, the silicide layer 92 forms discrete charge storage segment portions of the floating gates 9 which fill back portions of the front side recesses 62 and the polysilicon layer 93 fills front portions of the front side recesses 62.

The front side opening 81 is then filled by forming the tunnel dielectric 11 and the channel 1 as described above. The tunnel dielectric 11 has a straight sidewall facing the polysilicon layer 93 portions of the floating gates 9 because the edges of layers 93 and edge of layers 19 exposed in the front side opening 81 are substantially planar with each other (i.e., the edges of layers 93 and 19 form a substantially planar surface of the cylindrical opening 81). Thus, since the recesses 62 are completely filled by layers 93 and layers 93 do not protrude into the opening beyond layers 19, the tunnel dielectric 11 is formed on the substantially planar surface which results in the straight sidewall of the tunnel dielectric. Thus, each of the plurality of discrete, vertically separated floating gates 9 is located in a recess 62 between the insulating layers 19, and the straight sidewall of the tunnel dielectric 11 layer contacts the discrete portion of the polysilicon layer 93 in each floating gate 9.

Next, similar to the step shown in Figure 4D, the stack 120 is patterned to form one or more back side openings 84 in the stack. The back side opening(s) 84 may be formed by photolithography and anisotropic etching of the stack. The opening(s) 84 may have a cut shape (e.g., a slit shape, such as a slit shaped trench). Then, a portion of the second material layers 91/121 are removed through the back side opening 84 to form back side recesses 64 between the first material layers 19. For example, portions of layers 91/121 may be removed by a timed selective wet etching using a liquid etching medium which selectively etches the material of layers 91/121 compared to the materials of layers 19. Thus, portions of the polysilicon layers 91/121 located in opening 81 outside (e.g., behind) the front side recesses 62 are removed such that the polysilicon layer 93, the silicide layer 92 and remaining portions of the polysilicon 91/121 layer remaining in the front side recesses 62 form discrete, vertically separated polysilicon-silicide-polysilicon floating gates 9. Each of the plurality of discrete, vertically separated floating gates 9 includes a discrete portion of the polysilicon layer 91, a discrete portion of the polysilicon layer 93 and a discrete portion of the silicide layer 92 located between the discrete portions of the polysilicon layers 91, 93.

Then, as shown in Figure 11C, the blocking dielectric layer 7 (also known as an inter-poly dielectric, IPD) is then formed in the back side recesses 64 through the back side opening 84 such that the blocking dielectric coats the sides of the back side recesses 64 and the back side of layers 19 exposed in the back side opening 84. Thus, the blocking dielectric 7 coats the back side of the first layer 91 of the charge storage region (e.g., floating gate) 9. The blocking dielectric layer 7 may comprise a silicon oxide layer deposited by conformal atomic layer deposition (ALD) or chemical vapor deposition (CVD). Other high-k dielectric materials, such as hafnium oxide, or multi-layer dielectrics (e.g., ONO) may be used instead or in addition to silicon oxide. Optionally, an insulating capping layer (e.g., silicon nitride) may be deposited into the back side openings 84 before the blocking dielectric 7 and may comprise a back portion of a multi-layer blocking dielectric. The blocking dielectric 7 may have a thickness of 6 to 20 nm. An optional anneal, such as a rapid thermal anneal, may be conducted after the blocking dielectric formation.

Similarly to the embodiment illustrated in Figure 4E above, the blocking dielectric layer 7 comprises a plurality of clam-shaped blocking dielectric segments 7a, 7b in the back side recesses 64 connected to each other by vertical portions 7c of the blocking dielectric layer 7 located on the exposed edges of the first material layers 19 in the back side opening 84. The blocking dielectric 7 is formed through the back side opening 84 (e.g., the cut area) such that the blocking dielectric 7 contacts the sidewall of the charge storage material (e.g., layer 91 of the floating gate 9) exposed between the first material layers 19.

The opening in the clam shaped blocking dielectric segments 7a, 7b, is then filled by a control gate 3 material. As described above, the control gate 3 material may comprise a metal, such as tungsten, TiN and tungsten, or a heavily doped semiconductor, such as polysilicon. The control gate material may be deposited by CVD and fills the remaining volume of the back side recesses 64 inside the clam shaped blocking dielectric 7 segments and the entire back side opening 84. The deposition of the control gate material is followed by etching the control gate material to remove it from the back side opening 84 using anisotropic etching, while leaving the control gate material inside the back side recesses 64 in the clam shaped blocking dielectric 7 segments. The remaining control gate material inside the back side recesses 64 forms the control gates 3 of the vertical NAND string.

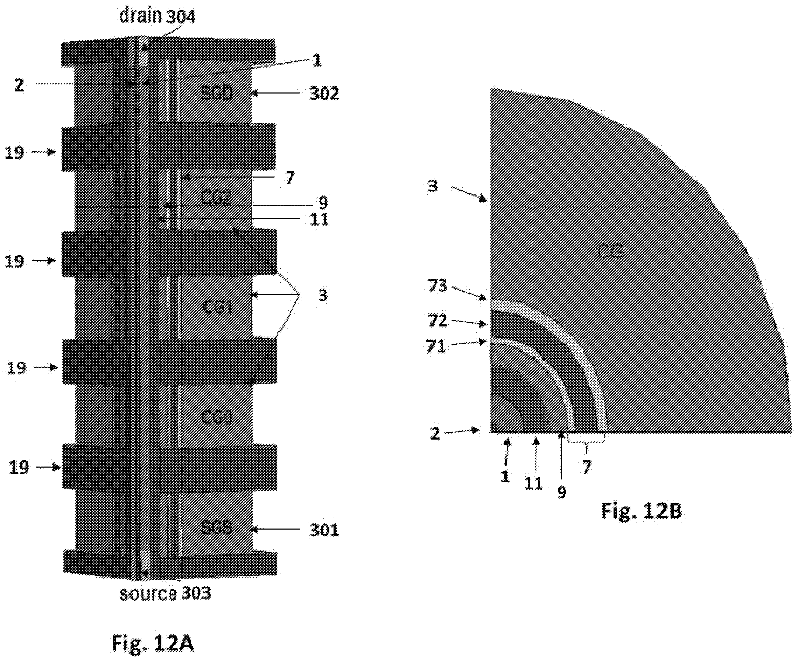

FIGs. 12A and 12B are respectively side cut away cross sectional and top cross sectional views of a NAND string of one embodiment. In the NAND string illustrated in Figure 12A, the stack includes three device levels as indicated by the three control gates CG0, CG1, CG2. However, the three dimensional NAND string of the present embodiment is not limited to three device levels. For example, the three dimensional NAND string may have 2-64 device levels, such as 2-32 device levels, such as 8-16 device levels. The NAND string also includes a source side select transistor and a drain side select transistor, containing the source side select gate SGS 301 and the drain gate select gate SGD 302. The channel region 1 contains doped source 303 and drain 304 regions at its opposite ends. The source and drain regions contact the respective electrodes shown in Figures 1A and 2A.

As illustrated in Figure 12B, an embodiment of a NAND string may include a three layer blocking dielectric 7. The three layer blocking dielectric 7 may include a first layer 71 comprising a nitride (e.g., silicon nitride), a second layer 72 comprising an oxide (e.g., silicon oxide), and a third layer 73 comprising another nitride (e.g., silicon nitride). In an embodiment, the NAND string includes insulating fill material 2 as illustrated in Figure 12B and discussed in regards to Figures 1A and 1B above. Any suitable radial layer thicknesses may be used, such as 3-20 nm, for example about 7 nm, for the channel 1 and tunnel dielectric 11, 1-5 nm, such as about 2 nm for the fill material 2, 3-15 nm, such as about 5 nm for the floating gate 9, and 10-20 nm, such as about 11 nm for the blocking dielectric 7 (e.g., about 2 nm/6nm/3nm for the respective nitride/oxide/nitride layers). Layers 19 may be 15-40 nm thick, such as about 25 nm thick in the vertical direction and the control gate layers 3 may be 20-50 nm thick, such as about 35 nm thick in the vertical direction. These exemplary dimensions provide a high width to length ratio of the device.

The three dimensional NAND string with a floating gate 9 made of three layers 91, 92, 93 has an excellent coupling ratio with a faster programming speed than a similar structure using a nitride trap charge storage layer. The NAND string also has the advantage of low cell to cell interference and low capacitive coupling between the adjacent cells. Additionally, the NAND string also has the advantage of low program noise and large program saturation due to its relatively large charge storage region and excellent blocking dielectric. The three dimensional NAND string of the present embodiment also has the advantage of a small channel relative to a two dimensional NAND string while also having the advantage of using Fowler-Nordheim tunneling versus hot hole injection used in nitride trap devices. This is advantageous because hot hole injection tends to cause more damage to the tunneling dielectric during programming than Fowler-Nordheim tunneling. Additionally, the three dimensional NAND string of the present embodiment has both excellent short term data retention and long term data retention. Further, the inventors have discovered that the three dimensional NAND string of the present embodiment may store four or more bits of information per memory cell.

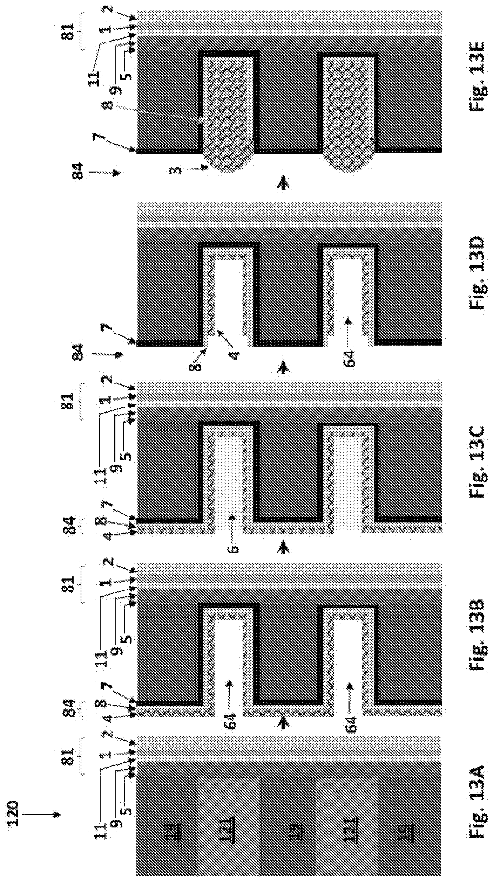

Figures 13A-13E are side cross sectional views illustrating a method beyond the scope of the claims of making a NAND string with copper control gates. The charge storage regions 9 may be floating gates or a dielectric charge storage layer. Referring to Figure 13A, a stack 120 of alternating layers 19 and 121 are formed over the major surface of the substrate 100 (not shown). Layers 19, 121 may be deposited over the substrate 100 by any suitable deposition method, such as sputtering, CVD, PECVD, MBE, etc.

As in the previous embodiments, the first layers 19 comprise an electrically insulating material. Any suitable insulating material may be used, such as silicon oxide, silicon nitride, silicon oxynitride, a high-k dielectric (e.g., aluminum oxide, hafnium oxide, etc. or an organic insulating material). The second layers 121 comprise a sacrificial material, such a semiconductor material or silicon nitride. For example, layers 121 may comprise silicon, such as amorphous silicon or polysilicon, or another semiconductor material, such as a group IV semiconductor, including silicon-germanium and germanium. Alternatively, the first layers may comprise silicon oxide and the second material layers comprise silicon nitride.

The deposition of layers 19, 121, is followed by etching the stack 120 to form at least one a front side opening 81 in the stack 120. An array of a front side openings 81 (e.g., memory holes) may be formed in locations where vertical channels of NAND strings will be subsequently formed. The openings 81 may be formed by photolithography and etching.

An optional cover layer 5 may then be formed in the openings 81 over the exposed sidewalls of the first 19 and second 121 layers. The cover layer 5 may be formed of any suitable material, such as SiO2. Cover layer 5 forms a front part of the blocking dielectric. A dielectric charge trapping material (e.g., silicon nitride) to form charge storage regions 9 is then formed over the cover layer 5. Alternatively a floating gate material may be used instead. Next, a tunnel dielectric 11 is formed over the charge trapping material. The channel 1 is then formed over the tunnel dielectric 11. Optionally, an insulating fill material 2 may be formed over the channel 1 if it desired to have a hollow cylindrical channel 1.

Next, as illustrated in Figure 13B, a back side opening 84 is formed in the stack 120 of alternating first 19 and second 121 layers. Then, the second material 121 is selectively etched compared to the first material 19 to form back side recesses 64 in the prior location of the second material layers 121 in the stack 120. The back side recesses 64 may be formed by selective, isotropic wet or dry etching which selectively etches the second material 121 compared to the first material 19.

Then, as shown in Figure 13B, the back part of the blocking dielectric layer 7 (also known as an inter-poly dielectric, IPD) is then formed in the back side recesses 64 through the back side opening 84 such that the blocking dielectric coats the sides of the back side recesses 64 and the back side of layers 19 exposed in the back side opening 84. The blocking dielectric layer 7 may comprise an aluminum oxide layer deposited by conformal atomic layer deposition (ALD) or chemical vapor deposition (CVD). As in previous embodiments, the blocking dielectric layer 7 comprises a plurality of clam-shaped blocking dielectric segments 7a, 7b in the back side recesses 64 connected to each other by vertical portions 7c.

A barrier layer 8 is then formed over the blocking dielectric layer 7. The barrier layer 8 may be made of any suitable material that prevents the diffusion of copper from a copper control gate into the materials located in the opening 81. As illustrated in Figure 13B, the copper barrier layer 8, similar to the blocking dielectric layer 7, has a clam shape. Suitable materials for the barrier layer 8 include, but are not limited to, Ta, Ti, TiN, TaN, TaCN, TaMnN, Ru, WN and MnN.

After forming the copper barrier layer 8, a copper seed layer 4 is formed on the exposed surfaces of the barrier layer 8 in the opening of the clam shaped copper barrier layer 8. The copper seed layer 4 assists in the formation of copper control gate electrodes 3 in the back side recesses 64. The copper seed layer 4, similar to the blocking dielectric 7 and the copper barrier layer 8, has a clam shape. A CVD process may be used to form the copper seed layer 4.

Next, as illustrated in Figure 13C, a sacrificial layer 6 is formed over the copper seed layer 4 in the back side recesses 64 via the back side openings 84 in the stack 120. The sacrificial layer 6 may be formed by deposition followed by anisotropic etch-back to remove sacrificial material 6 in the back side openings 84. Materials that may be used for the sacrificial material 6 include polysilicon, silicon nitride and silicon oxide. The sacrificial layer 6 protects the barrier layer 8 and the copper seed layer 4 in the back side recesses 64 during the removal of the barrier layer and the copper seed layer 4 from the back side opening 84 discussed in the step shown in Figure 13D and discussed below.

Next, as illustrated in Figure 13D, the portion of the copper seed layer 4 and the barrier layer 8 in the back side opening 84 are removed from the back side opening 84, such as by chemical wet etching. The blocking dielectric 7 lining the side walls of the back side opening protects the first layers 19 from chemical attack from the etching solution. Then, as illustrated in Figure 13D, the remaining sacrificial material 6 in the back side recesses 64 is removed to expose the copper seed layer 4 in the back side recesses 64.

Then, as illustrated in Figure 13E, the copper control gates 3 can be formed on the copper seed layer 4 by filling the back side recesses 64 with copper. The copper control gates 3 can be selectively formed by electrochemical deposition using the copper seed layer 4 as a deposition electrode. An advantage of the electrochemical method is that copper only selectively grows on the copper seed layer 4. Optionally, a wet etch may be performed after forming the copper control gates 3 to remove any excess copper that extends out of the back side recesses 64 into the back side opening 84.

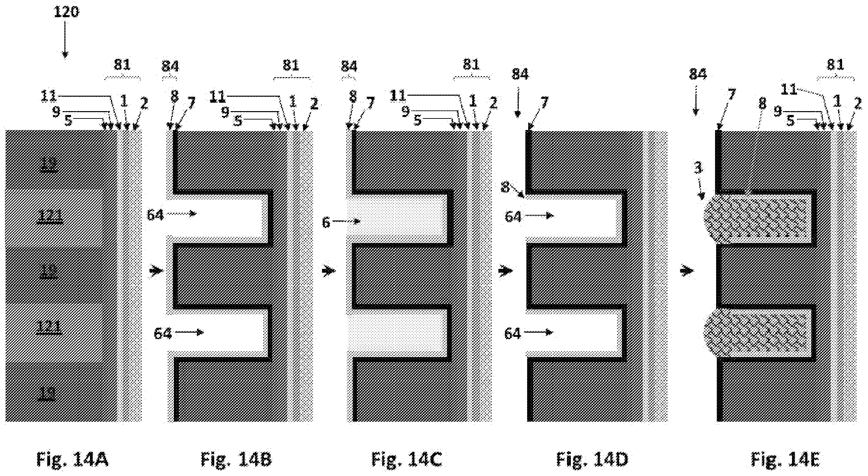

Figures 14A-14E are side cross sectional views illustrating a method beyond the scope of the claims of making a NAND strings with copper control gates 3. The barrier layer 8 acts as a copper nucleation layer, and the copper seed layer is omitted. Similar to the last method, a stack 120 of alternating layers 19 and 121 are formed over the major surface of the substrate 100 (not shown), as illustrated in Figure 14A. The first layers 19 comprise an electrically insulating material, such as silicon oxide, silicon nitride, silicon oxynitride or a high-k dielectric while the second layers 121 comprise a sacrificial material, such a semiconductor material or silicon nitride.

As in the previous method, the deposition of the stack 120 of alternating layers 19, 121 is followed by etching the stack 120 to form at least one a front side opening 81 in the stack 120. A cover layer 5 is then formed in at least one opening 81 over the exposed sidewalls of the first 19 and second 121 layers. The cover layer 5 may be formed of any suitable material, such as SiO2. Then a charge trapping material is formed over the cover layer 5 to form charge storage regions 9. Next, a tunnel dielectric 11 is formed over the charge trapping material. The channel 1 is then formed over the tunnel dielectric 11. As in the previous method, an optional insulating fill material 2 may be formed over the channel 1.

Then, as shown in Figure 14B, the blocking dielectric layer 7 (also known as an inter-poly dielectric, IPD) is then formed in the back side recesses 64 through the back side opening 84 such that the blocking dielectric coats the sides of the back side recesses 64 and the back side of layers 19 exposed in the back side opening 84. The blocking dielectric layer 7 may comprise an aluminum oxide layer deposited by conformal atomic layer deposition (ALD) or chemical vapor deposition (CVD).

A barrier layer 8 is then formed over the blocking dielectric layer 7. The copper barrier layer 8, as in the previous method, may be made of any suitable material that prevents the diffusion of copper from a copper control gate into the materials located in the opening 81. Suitable materials for the barrier layer 8 include, but are not limited to, Ta, Ti, TiN, TaN, TaCN, TaMnN, Ru, WN and MnN. In this method, a copper seed layer 4 is not used. Rather, the material of the barrier layer 8 is selected which preferentially nucleates copper.

Next, as illustrated in Figure 14C, a sacrificial layer 6 is formed over the barrier layer 8 in the back side recesses 64 via the back side openings 84 in the stack 120. The sacrificial layer 6 may be formed by deposition followed by anisotropic etch-back to remove sacrificial material 6 in the back side openings 84. Materials that may be used for the sacrificial material 6 include polysilicon, silicon nitride and silicon oxide. The sacrificial layer 6 protects the barrier layer 8 in the back side recesses 64 during the removal of the barrier layer 8 from the back side opening 84 discussed in regards to Figure 14D below.

Next, as illustrated in Figure 14D, the portion of the barrier layer 8 in the back side opening 84 is removed from the back side opening 84, such as by chemical wet etching. The blocking dielectric 7 lining the side walls of the back side opening protects the first layers 19 from chemical attack from the etching solution. Then, as illustrated in Figure 14D, the remaining sacrificial material 6 in the back side recesses 64 is removed to expose the copper barrier layer (copper nucleation layer) 8 in the back side recesses 64.

Then, as illustrated in Figure 14E, the copper control gates 3 can be selectively formed on the copper barrier layer (copper nucleation layer) 8 by filling the back side recesses 64 with copper. The copper control gates 3 can be formed by "seedless" electrochemical deposition using the copper barrier layer (copper nucleation layer) 8 as a deposition electrode. An advantage of the electrochemical method is that copper only selectively grows on the copper barrier layer (copper nucleation layer) 8. Optionally, a wet etch may be performed after forming the copper control gates 3 to remove any excess copper that extends out of the back side recesses 64 into the back side opening 84.

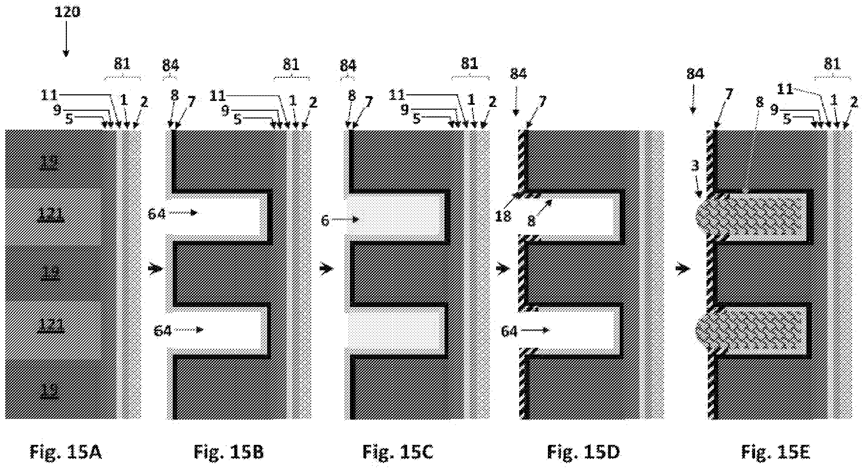

Figures 15A-15E are side cross sectional views illustrating a method of making a NAND strings with copper control gate electrodes according to an embodiment of the invention. In this embodiment, the barrier layer 8 exposed in the back side opening 84 is oxidized to form insulating regions rather than removed as in the prior method. Similar to the last method, a stack 120 of alternating layers 19 and 121 are formed over the major surface of the substrate 100 (not shown) as illustrated in Figure 15A. The first layers 19 comprise an electrically insulating material, such as silicon oxide, silicon nitride, silicon oxynitride or a high-k dielectric while the second layers 121 comprise a sacrificial material, such a semiconductor material or silicon nitride.

As in the previous method, the deposition of the stack 120 of alternating layers 19, 121 is followed by etching the stack 120 to form at least one a front side opening 81 in the stack 120. A cover layer 5 is then formed in at least one opening 81 over the exposed sidewalls of the first 19 and second 121 layers. The cover layer 5 may be formed of any suitable material, such as SiO2. Then a charge trapping material is formed over the cover layer 5 to form charge storage regions 9. Next, a tunnel dielectric 11 is formed over the charge trapping material. The channel 1 is then formed over the tunnel dielectric 11. As in the previous method, an optional insulating fill material 2 may be formed over the channel 1.

Then, as shown in Figure 15B, the blocking dielectric layer 7 (also known as an inter-poly dielectric, IPD) is then formed in the back side recesses 64 through the back side opening 84 such that the blocking dielectric coats the sides of the back side recesses 64 and the back side of layers 19 exposed in the back side opening 84. The blocking dielectric layer 7 may comprise an aluminum oxide layer deposited by conformal atomic layer deposition (ALD) or chemical vapor deposition (CVD).

A barrier layer 8 is then formed over the blocking dielectric layer 7. In this embodiment, the barrier layer 8 is made of tantalum or another material which can be oxidized to form insulating metal oxide regions exposed in the back side opening 84. The tantalum copper barrier layer may be form by chemical vapor deposition. Tantalum preferentially nucleates copper. The barrier layer 8 is also a copper nucleation layer.

Next, as illustrated in Figure 15C, a sacrificial layer 6 is formed over the barrier layer 8 in the back side recesses 64 via the back side openings 84 in the stack 120. The sacrificial layer 6 may be formed by deposition followed by anisotropic etch-back to remove sacrificial material 6 in the back side openings 84. Materials that may be used for the sacrificial material 6 include polysilicon, silicon nitride and silicon oxide. The sacrificial layer 6 protects the tantalum barrier layer 8 in the back side recesses 64 during the oxidation of the barrier layer from the back side opening 84 discussed in regards to Figure 15D below.

Next, as illustrated in Figure 15D, the tantalum barrier layer 8 exposed in the back side opening 84 is oxidized to form insulating tantalum oxide regions 18 in the back side opening 84. If the sacrificial layer 6 is recessed in the back side recesses 64 during removal of the sacrificial layer 6 from the back side openings 84, exposed portions of the tantalum barrier layer 8 in the back side recesses 64 are also oxidized. After oxidizing the tantalum barrier layer 8 in the back side openings 84 (and any exposed portions of the tantalum barrier layer 8 in the back side recesses 64), the remaining sacrificial material 6 in the back side recesses 64 is removed to expose remaining tantalum barrier layer 8 in the back side recesses 64.

Then, as illustrated in Figure 15E, the copper control gates 3 are selectively formed on the exposed tantalum blocking layer 8 by filling the back side recesses 64 with copper. In an embodiment, the copper control gates 3 are formed by "seedless" electrochemical deposition using the tantalum barrier layer 8 as a deposition electrode. However, control gates 3 are not deposited on the tantalum oxide regions 18 in the back side openings 84. Thus, selectively electrochemically depositing copper on the remaining first barrier layer 8 using the first barrier layer 8 as a copper nucleation layer without depositing copper on the oxidized portions 18 of the first blocking layer 8. In an embodiment, the first barrier layer 8 comprises a conductive clam shaped first portion in contact with the control gate electrodes 3 and a non-conductive metal oxide second portion 18 adjacent insulating layers (first material layers 19) separating the control gates 3 from each other. Optionally, a wet etch may be performed after forming the copper control gates 3 to remove any excess copper that extends out of the back side recesses 64 into the back side opening 84.

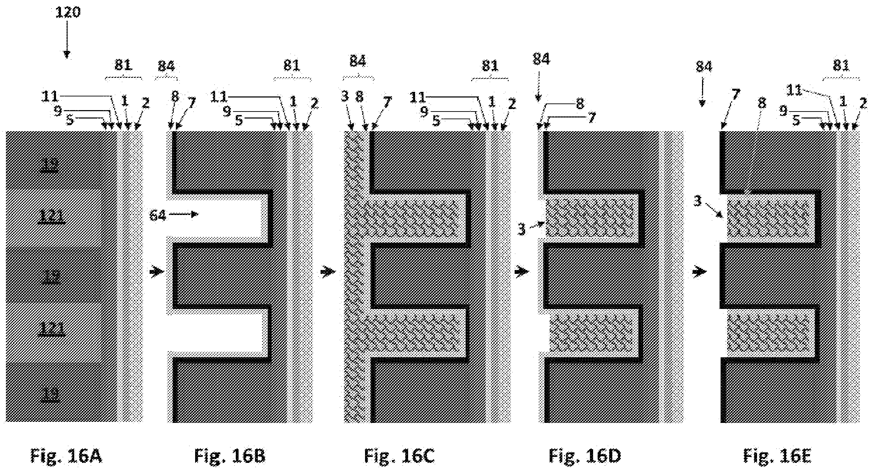

Figures 16A-16E are side cross sectional views illustrating a method beyond the scope of the claims of making a NAND strings with copper control gates. In this method, a copper layer is formed non-selectively and then etched back to form the copper control gates 3. Similar to the last embodiment, a stack 120 of alternating layers 19 and 121 are formed over the major surface of the substrate 100 (not shown) as illustrated in Figure 16A. The first layers 19 comprise an electrically insulating material, such as silicon oxide, silicon nitride, silicon oxynitride or a high-k dielectric while the second layers 121 comprise a sacrificial material, such a semiconductor material or silicon nitride.

As in the previous embodiment, the deposition of the stack 120 of alternating layers 19, 121 is followed by etching the stack 120 to form at least one a front side opening 81 in the stack 120. A cover layer 5 is then formed in at least one opening 81 over the exposed sidewalls of the first 19 and second 121 layers. The cover layer 5 may be formed of any suitable material, such as SiO2. Then a charge trapping material is formed over the cover layer 5 to form charge storage regions 9. Next, a tunnel dielectric 11 is formed over the charge trapping material. The channel 1 is then formed over the tunnel dielectric 11. As in the previous embodiment, an optional insulating fill material 2 may be formed over the channel 1.

Then, as shown in Figure 16B, the blocking dielectric layer 7 is then formed in the back side recesses 64 through the back side opening 84 such that the blocking dielectric coats the sides of the back side recesses 64 and the back side of layers 19 exposed in the back side opening 84. The blocking dielectric layer 7 may comprise an aluminum oxide layer deposited by conformal atomic layer deposition (ALD) or chemical vapor deposition (CVD).

Similar to the arrangement illustrated in Figure 13B, a barrier layer 8 is then formed over the blocking dielectric layer 7. The barrier layer 8 may be made of any suitable material that prevents the diffusion of copper from a copper control gate into the materials located in the opening 81. Suitable materials for the barrier layer 8 include, but are not limited to, Ta, Ti, TiN, TaN, TaCN, TaMnN, Ru, WN or MnN.

Next, as illustrated in Figure 16C, copper is deposited in the back side recesses 64 via the back side openings 84 to form copper control gate electrodes 3. In this method, the copper is non-selectively deposited by chemical vapor deposition. That is, in this method, neither a copper seed layer 4 nor a copper nucleation material is needed prior to chemical vapor deposition.

Then, as illustrated in Figure 16D, copper material in the back side openings 84 is removed. The copper material in the back side openings 84 may be removed, for example, by isotropic chemical dry etching. A portion of the copper material in the back side recesses 64 may be recessed during step of removing copper from the back side openings 84.

Next as illustrated in Figure 16E, a selective etch may be performed to remove the exposed barrier layer 8 on the side walls of the back side openings 84. The selective etch may be a highly selective isotropic wet etch or an anisotropic reactive ion etch (RIE) step. Alternatively, a combination of a selective isotropic etch and an anisotropic etch may be used.

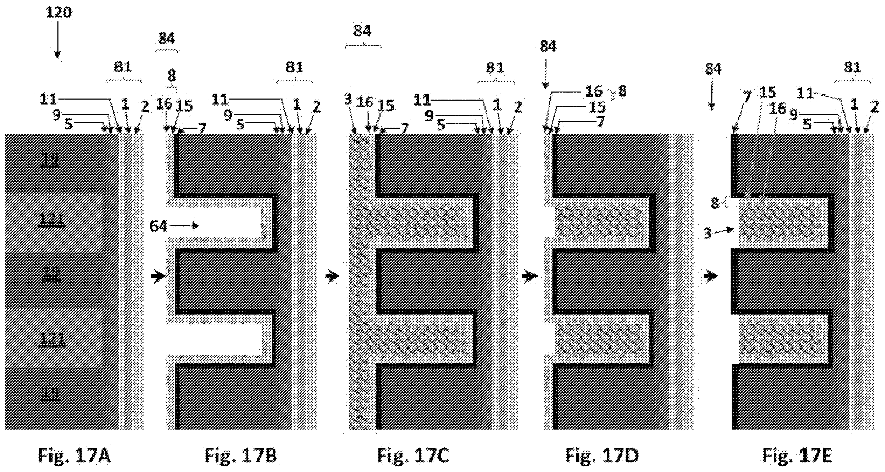

Figures 17A-17E are side cross sectional views illustrating a method beyond the scope of the claims of making a NAND strings with copper control gates in which a dual layer barrier film is used. Similar to the last method, a stack 120 of alternating layers 19 and 121 are formed over the major surface of the substrate 100 (not shown) as illustrated in Figure 17A. The first layers 19 comprise an electrically insulating material, such as silicon oxide, silicon nitride, silicon oxynitride or a high-k dielectric while the second layers 121 comprise a sacrificial material, such a semiconductor material or silicon nitride.

As in the previous method, the deposition of the stack 120 of alternating layers 19, 121 is followed by etching the stack 120 to form at least one a front side opening 81 in the stack 120. A cover layer 5 is then formed in at least one opening 81 over the exposed sidewalls of the first 19 and second 121 layers. The cover layer 5 may be formed of any suitable material, such as SiO2. Then a charge trapping material is formed over the cover layer 5 to form charge storage regions 9. Next, a tunnel dielectric 11 is formed over the charge trapping material. The channel 1 is then formed over the tunnel dielectric 11. As in the previous method, an optional insulating fill material 2 may be formed over the channel 1.

Then, as shown in Figure 17B, the blocking dielectric layer 7 is then formed in the back side recesses 64 through the back side opening 84 such that the blocking dielectric coats the sides of the back side recesses 64 and the back side of layers 19 exposed in the back side opening 84. The blocking dielectric layer 7 may comprise an aluminum oxide layer deposited by conformal atomic layer deposition (ALD) or chemical vapor deposition (CVD).

A barrier layer 8 is then formed over the blocking dielectric layer 7. In this method, the barrier layer 8 comprises a bilayer film comprising a titanium nitride layer 15 and a tungsten layer 16. The titanium nitride layer 15 may be formed by any suitable method, such as ALD or CVD. The tungsten layer 16 may be formed by fluorine free atomic layer deposition process over the titanium nitride layer 15.

Next, as illustrated in Figure 17C and similar to the previous method, copper is deposited in the back side recesses 64 via the back side openings 84 to form copper control gate electrodes 3. In this method, the copper is non-selectively deposited by chemical vapor deposition. That is, in this method, neither a copper seed layer 4 nor a copper nucleation material is needed.

However, in an alternative method, a thin copper seed layer 4 may be first deposited using chemical vapor deposition in the back side recesses on the tungsten layer 16. The copper control gate electrodes 3 may then be selectively formed in the back side recesses 64 by electrochemical deposition. A thin copper seed layer 4 may be first deposited on the tungsten layer 16 in the back side recesses using an electroless plating process followed by selectively forming the control gate electrodes 3 using electrochemical deposition using the copper seed layer 4 as a deposition electrode.

Then, as illustrated in Figure 17D, copper material in the back side openings 84 is removed. The copper material in the back side openings 84 may be removed, for example, by isotropic chemical dry etching. A portion of the copper material in the back side recesses 64 may be recessed during step of removing copper from the back side openings 84.

Next as illustrated in Figure 17E, a selective etch may be performed to remove the exposed barrier layer 8 (i.e. the TiN layer 15 and the tungsten layer 16) on the side walls of the back side openings 84. The selective etch may be a highly selective isotropic wet etch or an anisotropic reactive ion etch (RIE) step. Alternatively, a combination of a selective isotropic etch and an anisotropic etch may be used.

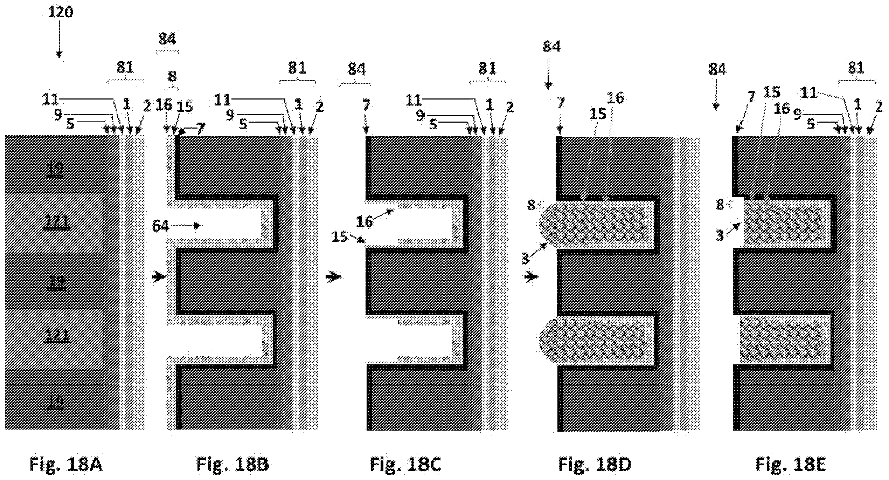

Figures 18A-18E are side cross sectional views illustrating a method of making NAND strings according to another embodiment. In this embodiment, a barrier layer is selectively recessed and the control gates may comprise copper or any other suitable material (e.g. tungsten). Similar to the last embodiment, a stack 120 of alternating layers 19 and 121 are formed over the major surface of the substrate 100 (not shown) as illustrated in Figure 18A. The first layers 19 comprise an electrically insulating material, such as silicon oxide, silicon nitride, silicon oxynitride or a high-k dielectric while the second layers 121 comprise a sacrificial material, such a semiconductor material (e.g., polysilicon) or silicon nitride.

As in the previous embodiments, the deposition of the stack 120 of alternating layers 19, 121 is followed by etching the stack 120 to form at least one a front side opening 81 in the stack 120. A cover layer 5 is then formed in at least one opening 81 over the exposed sidewalls of the first 19 and second 121 layers. The cover layer 5 may be formed of any suitable material, such as SiO2. Then a charge trapping material is formed over the cover layer 5 to form charge storage regions 9. Next, a tunnel dielectric 11 is formed over the charge trapping material. The channel 1 is then formed over the tunnel dielectric 11. As in the previous embodiment, an optional insulating fill material 2 may be formed over the channel 1.

Then, as shown in Figure 18B, the blocking dielectric layer 7 is then formed in the back side recesses 64 through the back side opening 84 such that the blocking dielectric coats the sides of the back side recesses 64 and the back side of layers 19 exposed in the back side opening 84. The blocking dielectric layer 7 may comprise an aluminum oxide layer deposited by conformal atomic layer deposition (ALD) or chemical vapor deposition (CVD).

A barrier layer 8 is then formed over the blocking dielectric layer 7. In this embodiment, the barrier layer 8 comprises a titanium nitride layer 15 and a tungsten layer 16. The titanium nitride layer 15 may be formed by any suitable method, such as ALD or CVD. The tungsten layer 16 may be formed by fluorine free atomic layer deposition process.

Next, as illustrated in Figure 18C, the titanium nitride layer 15 and the tungsten layer 16 are removed from the sidewalls of the backside openings 84. A selective etch may be used remove the titanium nitride layer 15 and the tungsten layer 16. Selective etches that may be used include anisotropic reactive ion etching. In an embodiment, the tungsten layer 16 may be recessed in the back side recesses 64 as illustrated in Figure 18C.

Then, as illustrated in Figure 18D, copper control gates 3 are formed in the back side recesses 64 on the barrier layer 8 (i.e. the exposed portion of the titanium nitride layer 15 and the tungsten layer 16). In an embodiment, copper control gates can be selectively deposited on the tungsten layer 15 by electroless plating or non-selectively deposited by CVD. Alternatively, a copper seed layer 4 can be deposited on the barrier layer 8 electrolessly or by CVD followed by formation of the copper control gates using electrochemical deposition. Alternatively, other metal control gates 3, such as cobalt or tungsten may be formed instead of copper control gates 3.

Next, as illustrated in Figure 18E, an isotropic wet etch may be performed after forming the control gates 3 to remove any excess metal that extends out of the back side recesses 64 into the back side opening 84. In an embodiment, the control gates 3 may be recessed in the back side recesses 64.

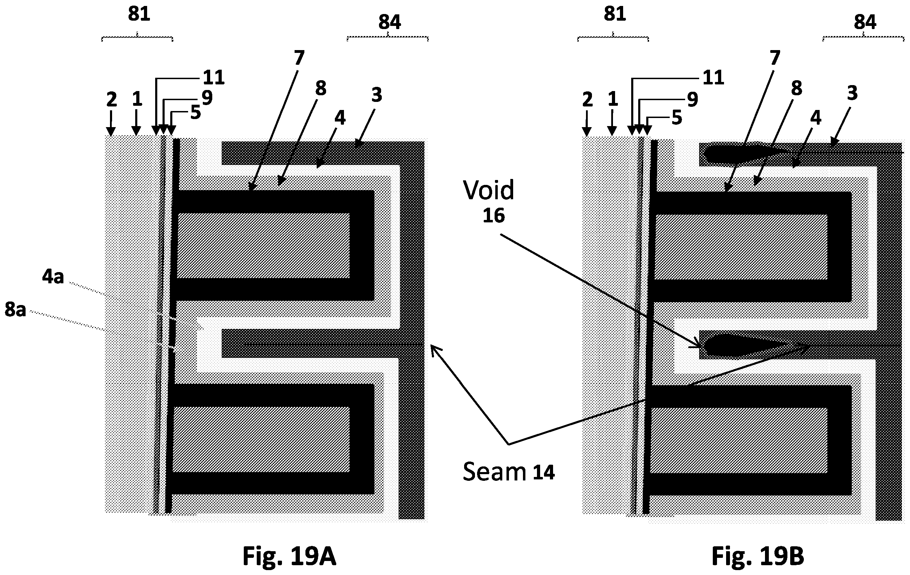

Figures 19A and 19B are side cross sectional views illustrating common defects in single step control gate 3 fabrication processes. As illustrated in Figure 19A, fabricating control gates 3 using a low temperature CVD process, such as a low temperature tungsten process, results in good filling of the back side recesses 64. However, control gates 3 made via a low temperature CVD process have a high resistivity (e.g. 18-22 µΩcm, such as 20 µΩcm) and exhibit a narrow seam 14 running down the center of the control gates 3, except for a small portion of the control gate electrode 3 adjacent the inner most portion 8a (nearest the front side opening 81), of the barrier layer 8 (or the inner most portion 4a of the optional seed layer 4, if provided). The seam 14 is a byproduct of the layer by layer growth of the control gate 3 from the surface of the barrier layer 8 (or seed layer 4) to the center of the back side recesses 64. Fabricating control gates 3 using a high temperature CVD process, such as a high temperature tungsten process, results in a low resistivity control gate (e.g. 10-14 µΩcm, such as 12 µΩcm). However, the recess fill is poor, resulting in the formation of voids 16 in the control gate 3, as illustrated in Figure 19B.

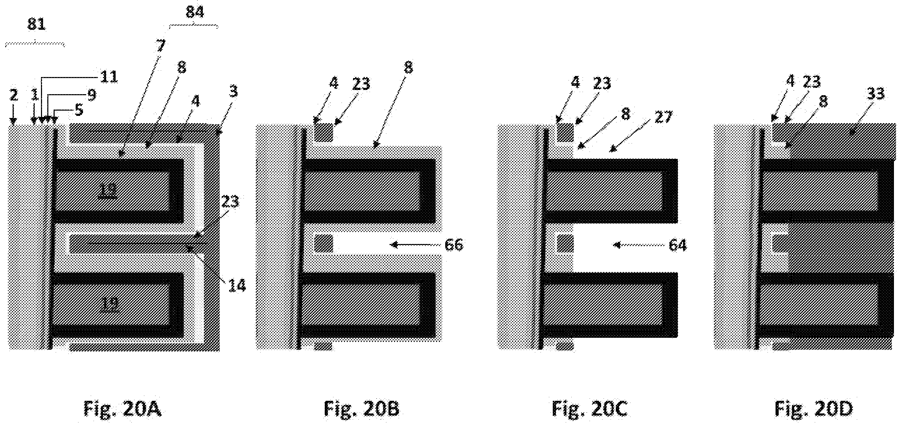

Figures 20A-20D are side cross sectional views illustrating an embodiment of a method of making NAND strings according to another embodiment in which the seam 14 and the voids 16 are reduced or eliminated. Similar to the above embodiments, a stack 120 of first material layers 19 and second material layers 121 with at least one front side opening 81 and a back side opening 84 is provided. The front side opening includes a cover layer 5, a charge trapping material 9, a tunnel dielectric 11, a semiconductor channel 1 and optionally, an insulating fill material 2. The back side recess 64 is lined with a blocking dielectric 7. Depending on the material chosen for the control gate electrode 3, the back side recess 64 may also include a barrier layer 8 and/or a copper seed layer 4. However, these layers are not required if the control gate 3 is made of tungsten or any other non-copper metal or alloy.

As illustrated in Figure 20A, a first control gate electrode layer 23 with a first thickness is formed inside the back side recesses 66 after forming the blocking dielectric 7 and the barrier layer 8. The first control gate layer 23 is a tungsten layer formed using a low temperature CVD process so that the only "defect" is a seam 14. That is, the first control gate layer 23 does not have any voids 16.

Next, as illustrated in Figure 20B, the first control gate electrode layer 23 is recessed to remove the seam 14. That is, the first control gate electrode layer 23 is recessed until the seamless portion near the front side opening 81 is reached. The first control gate layer 23 may be recessed by either dry etching or wet etching.

Then, as illustrated in Figure 20C, the barrier layer 8 (and optional seed layer 4 if provided) is recessed until the recessed first control gate layer 23 is reached. In an embodiment, the exposed surface of the barrier layer 8 (and optional seed layer 4) is flush with the exposed surface of the first control gate layer 23. Recessing the barrier layer 8 (and optional seed layer 4) results in exposing a portion 27 of the blocking dielectric inside the back side recesses 64.

Then, as illustrated in Figure 20D, a second control gate layer 33 with a second thickness is formed inside the back side recesses 64 on the blocking dielectric 7. No seam 14 is produced in the second control gate layer 33 because the width of the back side recess 64 is larger than the width of the back side recess 66 and/or the growth of layer 33 initiates at the remaining portion of the first control gate layer 23 and proceeds in one direction toward the back side opening 84 (rather than from the two opposite sides of the barrier layer 8 in the back side recesses 66).

Although the foregoing refers to particular disclosed embodiments, it will be understood that the disclosure is not so limited. It will occur to those of ordinary skill in the art that various modifications may be made to the disclosed embodiments and that such modifications are intended to be within the scope of the disclosure, the scope being defined by the appended claims.

## Claims

1. A method of making a monolithic three dimensional NAND string (180), comprising:
providing a stack of alternating first material layers (19) and second material layers (121) over a substrate (100), wherein the first material layers (19) comprise an insulating material (19) and the second material layers (121) comprise sacrificial layers (121);
forming a first side opening (84) in the stack on a first side of a stack portion;
selectively removing the second material layers (121) through the first side opening (84) to form first side recesses (64) between adjacent first material layers (19);
forming a blocking dielectric (7) inside the first side recesses (64) and the first side opening (84), the blocking dielectric (7) having a clam shaped regions inside the first side recesses (64);
forming a first barrier layer (8) over the blocking dielectric (7) inside the first side recesses (64) and the first side opening (84); and
forming a plurality of copper control gate electrodes (3) in the respective clam shell shaped regions of the blocking dielectric (7) in the first side recesses (64);
wherein:
the first barrier layer (8) has clam shaped regions inside the clam shaped regions in the blocking dielectric (7) the first side recesses (64); and
the plurality of copper control gate electrodes (3) are formed in the respective clam shell shaped regions of the first barrier layer (8) in the first side recesses (64);
the method **characterized in that** forming a plurality of copper control gate electrodes (3) comprises:
forming a sacrificial film on the first barrier layer (8) in the first side opening (84) and the first side recesses (64), wherein the first barrier layer (8) is a copper nucleation layer;
anisotropically etching the sacrificial layer (6) in the first side opening (84) and recessing the sacrificial layer (6) in the first side recesses (64) to expose the first barrier layer (8) in the first side opening (84) and a portion of the first barrier layer (8) in the first side recesses (64);
oxidizing the exposed first barrier layer (8) in the first side opening (84) and the first side recesses (64);
removing the sacrificial layer (6) to expose the remaining first barrier layer (8) in the first side recesses (64); and
selectively electrochemically depositing copper on the remaining first barrier layer (8) using the first barrier layer (8) as a copper nucleation layer without depositing copper on the oxidized portions (18) of the first barrier layer (8).

2. The method of claim 1, further comprising:
forming at least one second side opening (81) in the stack on a second side of the stack portion, wherein the second side of the stack portion is opposite the first side;
forming at least one charge storage region (9) in the at least one opening;
forming a tunnel dielectric layer (11) over the at least one charge storage region in the second side opening; and
forming a semiconductor channel (1) on the tunnel dielectric in the second side opening.

3. The method of claim 2, further comprising:
forming a cover layer (5) on a sidewall of second side opening prior to forming the at least one charge storage layer; and
forming an insulating fill material (2) in the central part of the at least one opening to completely fill the at least one opening.

4. The method of claim 1, wherein the blocking dielectric comprises Al₂O₃ and the first barrier layer comprises Ta, Ti, TiN, TaN, TaCN, TaMnN, Ru, WN or MnN,.

5. The method of claim 4, wherein the first barrier layer is formed by atomic layer deposition.

6. The method of claim 1, wherein the sacrificial film comprises polysilicon, silicon nitride or SiO₂.

7. The method of claim 1, wherein forming the plurality of copper control gate electrodes comprises:
forming a plurality of first control gate layers (23) in the respective clam shell shaped regions of the first barrier layer in the first side recesses, wherein the first barrier layers and the first control gate layers completely fill the first side recesses;
selectively recessing the first control gate layer and the first barrier layer in the first side recesses; and
forming a plurality of second control gate layers (33) in the respective clam shell shaped regions of the blocking dielectric in the first side recesses;
or:
forming a plurality of first control gate layers in the respective clam shell shaped regions of the first barrier layer in the first side recesses, wherein the first barrier layers and the first control gate layers partially fill the first side recesses;
selectively recessing the first control gate layers and the first barrier layers in the first side recesses; and
forming a plurality of second control gate layers in the respective clam shell shaped regions of the blocking dielectric in the first side recesses.

8. The method of claim 1, wherein:
the substrate comprises a silicon substrate;
the monolithic three dimensional NAND string is located in an array of monolithic three dimensional NAND strings over the silicon substrate;
at least one memory cell in a first device level of the three dimensional array of NAND strings is located over another memory cell in a second device level of the three dimensional array of NAND strings; and
the silicon substrate contains an integrated circuit comprising a driver circuit for the memory device located thereon.

## Patentansprüche

1. Verfahren zur Herstellung einer monolithischen dreidimensionalen NAND-Kette (180), umfassend:
Bereitstellen eines Stapels aus alternierenden ersten Materialschichten (19) und zweiten Materialschichten (121) über einem Substrat (100), wobei die ersten Materialschichten (19) ein isolierendes Material (19) umfassen und die zweiten Materialschichten (121) Opferschichten (121) umfassen;
Bilden einer ersten Seitenöffnung (84) in dem Stapel auf einer ersten Seite eines Stapelabschnitts;
selektives Entfernen der zweiten Materialschichten (121) durch die erste Seitenöffnung (84), um erste Seitenaussparungen (64) zwischen angrenzenden ersten Materialschichten (19) zu bilden;
Bilden eines blockierenden Dielektrikums (7) innerhalb der ersten Seitenaussparungen (64) und der ersten Seitenöffnung (84), wobei das blockierende Dielektrikum (7) einen zweischalenförmigen Bereich innerhalb der ersten Seitenaussparungen (64) aufweist;
Bilden einer ersten Barriereschicht (8) über dem blockierenden Dielektrikum (7) innerhalb der ersten Seitenaussparungen (64) und der ersten Seitenöffnung (84); und
Bilden einer Vielzahl von Kupfer-Steuergate-Elektroden (3) in den jeweiligen zweischalenförmigen Bereichen des blockierenden Dielektrikums (7) in den ersten Seitenaussparungen (64);
wobei:
die erste Barriereschicht (8) zweischalenförmige Bereiche innerhalb der zweischalenförmigen Bereiche im blockierenden Dielektrikum (7) in den ersten Seitenaussparungen (64) aufweist; und
die Vielzahl von Kupfer-Steuergate-Elektroden (3) in den jeweiligen zweischalenförmigen Bereichen der ersten Barriereschicht (8) in den ersten Seitenaussparungen (64) gebildet sind;
das Verfahren **dadurch gekennzeichnet ist, dass** das Bilden einer Vielzahl von Kupfer-Steuergate-Elektroden (3) Folgendes umfasst:
Bilden eines Opferfilms auf der ersten Barriereschicht (8) in der ersten Seitenöffnung (84) und den ersten Seitenaussparungen (64), wobei die erste Barriereschicht (8) eine Kupfer-Nukleierungsschicht ist;
anisotropes Ätzen der Opferschicht (6) in der ersten Seitenöffnung (84) und Aussparen der Opferschicht (6) in den ersten Seitenaussparungen (64), um die erste Barriereschicht (8) in der ersten Seitenöffnung (84) und einen Abschnitt der ersten Barriereschicht (8) in den ersten Seitenaussparungen (64) freizulegen;
Oxidieren der freigelegten ersten Barriereschicht (8) in der ersten Seitenöffnung (84) und den ersten Seitenaussparungen (64);
Entfernen der Opferschicht (6), um die verbleibende erste Barriereschicht (8) in den ersten Seitenaussparungen (64) freizulegen; und
selektives elektrochemisches Abscheiden von Kupfer auf der verbleibenden ersten Barriereschicht (8) unter Verwendung der ersten Barriereschicht (8) als eine Kupfer-Nukleierungsschicht, ohne dass Kupfer auf den oxidierten Abschnitten (18) der ersten Barriereschicht (8) abgeschieden wird.

2. Verfahren nach Anspruch 1, weiter umfassend:
Bilden mindestens einer zweiten Seitenöffnung (81) in dem Stapel auf einer zweiten Seite des Stapelabschnitts, wobei die zweite Seite des Stapelabschnitts der ersten Seite gegenüberliegt;
Bilden mindestens eines Ladungsspeicherbereichs (9) in der mindestens einen Öffnung;
Bilden einer dielektrischen Tunnelschicht (11) über dem mindestens einen Ladungsspeicherbereich in der zweiten Seitenöffnung; und
Bilden eines Halbleiterkanals (1) auf dem Tunneldielektrikum in der zweiten Seitenöffnung.

3. Verfahren nach Anspruch 2, weiter umfassend:
Bilden einer Deckschicht (5) auf einer Seitenwand der zweiten Seitenöffnung vor dem Bilden der mindestens einen Ladungsspeicherschicht; und
Bilden eines isolierenden Füllmaterials (2) im zentralen Teil der mindestens einen Öffnung, um die mindestens eine Öffnung vollständig zu füllen.

4. Verfahren nach Anspruch 1, wobei das blockierende Dielektrikum Al₂O₃ umfasst und die erste Barriereschicht Ta, Ti, TiN, TaN, TaCN, TaMnN, Ru, WN oder MnN umfasst.

5. Verfahren nach Anspruch 4, wobei die erste Barriereschicht durch Atomlagenabscheidung gebildet wird.

6. Verfahren nach Anspruch 1, wobei die Opferschicht Polysilizium, Siliziumnitrid oder SiO₂ umfasst.

7. Verfahren nach Anspruch 1, wobei das Bilden der Vielzahl von Kupfer-Steuergate-Elektroden Folgendes umfasst:
Bilden einer Vielzahl von ersten Steuergate-Schichten (23) in den jeweiligen zweischalenförmigen Bereichen der ersten Barriereschicht in den ersten Seitenaussparungen, wobei die ersten Barriereschichten und die ersten Steuergate-Schichten die ersten Seitenaussparungen vollständig ausfüllen;
selektives Aussparen der ersten Steuergate-Schicht und der ersten Barriereschicht in den ersten Seitenaussparungen; und
Bilden einer Vielzahl von zweiten Steuergate-Schichten (33) in den jeweiligen zweischalenförmigen Bereichen des blockierenden Dielektrikums in den ersten Seitenaussparungen;
oder:
Bilden einer Vielzahl von ersten Steuergate-Schichten in den jeweiligen zweischalenförmigen Bereichen der ersten Barriereschicht in den ersten Seitenaussparungen, wobei die ersten Barriereschichten und die ersten Steuergate-Schichten die ersten Seitenaussparungen teilweise ausfüllen;
selektives Aussparen der ersten Steuergate-Schichten und der ersten Barriereschichten in den ersten Seitenaussparungen; und
Bilden einer Vielzahl von zweiten Steuergate-Schichten in den jeweiligen zweischalenförmigen Bereichen des blockierenden Dielektrikums in den ersten Seitenaussparungen.

8. Verfahren nach Anspruch 1, wobei:
die monolithische dreidimensionale NAND-Kette in einem Array von monolithischen dreidimensionalen NAND-Ketten über dem Siliziumsubstrat angeordnet ist;
mindestens eine Speicherzelle in einer ersten Vorrichtungsebene des dreidimensionalen Arrays von NAND-Ketten über einer anderen Speicherzelle in einer zweiten Vorrichtungsebene des dreidimensionalen Arrays von NAND-Ketten angeordnet ist; und
das Siliziumsubstrat eine integrierte Schaltung enthält, die eine darauf angeordnete Treiberschaltung für die Speichervorrichtung umfasst.

## Revendications

1. Procédé de fabrication d'une chaîne NAND tridimensionnelle monolithique (180) comprenant :
la fourniture d'une pile de couches de premier matériau (19) et de couches de second matériau (121) sur un substrat (100), dans lequel les couches de premier matériau (19) comportent un matériau isolant (19) et les couches de second matériau (121) comportent des couches sacrificielles (121) ;
la formation d'une ouverture de premier côté (84) dans la pile sur un premier côté d'une partie de pile ;
le retrait sélectif des couches de second matériau (121) à travers l'ouverture de premier côté (84) pour former des creux de premier côté entre des couches de premier matériau adjacentes (19) ;
la formation d'un diélectrique de blocage (7) dans les creux de premier côté (64) et l'ouverture de premier côté (84), le diélectrique de blocage (7) ayant des régions en forme de palourde dans les creux de premier côté (64) ;
la formation d'une première couche barrière (8) sur le diélectrique de blocage (7) dans les creux de premier côté (64) et l'ouverture de premier côté (84) ; et
la formation d'une pluralité d'électrodes grilles de commande en cuivre (3) dans les régions en forme de coquille de palourde respectives du diélectrique de blocage (7) dans les creux de premier côté (64) ;
dans lequel :
la première couche barrière (8) comporte des régions en forme de palourde dans les régions en forme de palourde dans le diélectrique de blocage (7) dans les creux de premier côté (64) ; et
la pluralité d'électrodes grilles de commande en cuivre (3) sont formées dans les régions en forme de coquille de palourde de la première couche barrière (8) dans les creux de premier côté (64) ;
le procédé **caractérisé en ce que** la formation d'une pluralité d'électrodes grilles de commande en cuivre (3) comprend :
la formation d'un film sacrificiel sur la première couche barrière (8) dans l'ouverture de premier côté (84) et les creux de premier côté (64), dans lequel la première couche barrière (8) est une couche de nucléation du cuivre ;
la gravure anisotropique de la couche sacrificielle (6) dans l'ouverture de premier côté (84) et l'enfoncement de la couche sacrificielle (6) dans les creux de premier côté (64) pour exposer la première couche barrière (8) dans l'ouverture de premier côté (84) et une partie de la première couche barrière (8) dans les creux de premier côté (64) ;
l'oxydation de la première couche barrière exposée (8) dans l'ouverture de premier côté (84) et les creux de premier côté (64) ;
le retrait de la couche sacrificielle (6) pour exposer la première couche barrière restante (8) dans les creux de premier côté (64) ; et
le dépôt sélectivement électrochimique du cuivre sur la première couche barrière restante (8) utilisant la première couche barrière (8) comme couche de nucléation du cuivre sans déposer le cuivre sur les parties oxydées (18) de la première couche barrière (8).

2. Procédé selon la revendication 1, comprenant en outre :
la formation d'au moins une ouverture de second côté (81) dans la pile sur un second côté d'une partie de pile, dans lequel le second côté de la partie de pile est opposé au premier côté ;
la formation d'au moins une région de stockage de charge (9) dans la au moins une ouverture ;
la formation d'une couche de diélectrique à effet tunnel (11) sur la au moins une région de stockage de charge dans l'ouverture de second côté ; et
la formation d'un canal semi-conducteur (1) sur le diélectrique à effet tunnel dans l'ouverture de second côté.

3. Procédé selon la revendication 2, comprenant en outre :
la formation d'une couche de recouvrement (5) sur une paroi latérale de l'ouverture de second côté avant de former la au moins une couche de stockage de charge ; et
la formation d'un matériau de remplissage isolant (2) dans la partie centrale de la au moins une ouverture pour remplir complètement la au moins une ouverture.

4. Procédé selon la revendication 1, dans lequel le diélectrique de blocage comprend Al₂O₃ et la première couche barrière comprend Ta, Ti, TiN, TaN, TaCN, TaMnN, Ru, WN ou MnN.

5. Procédé selon la revendication 4, dans lequel la première couche barrière est formée par un dépôt de couches atomiques.

6. Procédé selon la revendication 1, dans lequel le film sacrificiel comprend du polysilicium, du nitrure de silicium ou du SiO₂.

7. Procédé selon la revendication 1, dans lequel la formation de la pluralité d'électrodes grilles de commande en cuivre comprend :
la formation d'une pluralité de premières couches de grille de commande (23) dans les régions en forme de coquille de palourde respectives de la première couche barrière dans les creux de premier côté, dans lequel les premières couches barrières et les premières couches de grille de commande remplissent complètement les creux de premier côté ;
l'enfoncement sélectif de la première couche de grille de commande et de la première couche barrière dans les creux de premier côté ; et
la formation d'une pluralité de secondes couches de grille de commande (33) dans les régions en forme de coquille de palourde respectives du diélectrique de blocage dans les creux de premier côté ;
ou :
la formation d'une pluralité de premières couches de grille de commande dans les régions en forme de coquille de palourde respectives de la première couche barrière dans les creux de premier côté, dans lequel les premières couches barrières et les premières couches de grille de commande remplissent partiellement les creux de premier côté ;
l'enfoncement sélectif des premières couches de grille de commande et des premières couches barrières dans les creux de premier côté ; et
la formation d'une pluralité de secondes couches de grille de commande dans les régions en forme de coquille de palourde respectives du diélectrique de blocage dans les creux de premier côté.

8. Procédé selon la revendication 1, dans lequel :
le substrat comprend un substrat de silicium ;
la chaîne NAND tridimensionnelle monolithique est située dans un ensemble de chaînes NAND tridimensionnelles monolithiques sur le substrat de silicium ;
au moins une cellule de mémoire dans le premier niveau de dispositif de l'ensemble tridimensionnel de chaînes NAND est située sur une autre cellule de mémoire dans un second niveau de dispositif de l'ensemble tridimensionnel de chaînes NAND ; et
le substrat de silicium contient un circuit intégré comprenant un circuit d'attaque pour le dispositif de mémoire situé sur celui-ci.
